(19) Europäisches Patentamt
European Patent Office
Office européen des brevets

(11) Publication number: **0 390 606 A2**

(12) # EUROPEAN PATENT APPLICATION

(21) Application number: 90303477.5

(22) Date of filing: 30.03.90

(51) Int. Cl.$^5$: H01L 27/146, H01L 29/08

(30) Priority: 31.03.89 JP 83212/89
31.03.89 JP 83213/89

(43) Date of publication of application:
03.10.90 Bulletin 90/40

(84) Designated Contracting States:
DE FR GB NL

(71) Applicant: CANON KABUSHIKI KAISHA
30-2, 3-chome, Shimomaruko, Ohta-ku
Tokyo(JP)

(72) Inventor: Ohmi, Tadahiro
1-17-301, Komegafukuro 2-chome, Aoba-ku
Sendai-shi, Miyagi-ken(JP)
Inventor: Miyawaki, Mamoru
2-5-302, Daida 6-chome, Setagaya-ku
Tokyo(JP)

(74) Representative: Beresford, Keith Denis Lewis et al
BERESFORD & Co. 2-5 Warwick Court High Holborn
London WC1R 5DJ(GB)

(54) **Semiconductor device having transistor improved in emitter region and/or base electrode.**

(57) There is provided a semiconductor device having an improved transistor having a structure in which the base-emitter junction is substantially flat and a region wherein a band gap is varied is provided within the emitter and/or a structure with the base electrode constituted of a metal material which is embedded internally of an insulating layer as the transistor capable of high speed driving and obtaining high current amplification.

FIG. 3

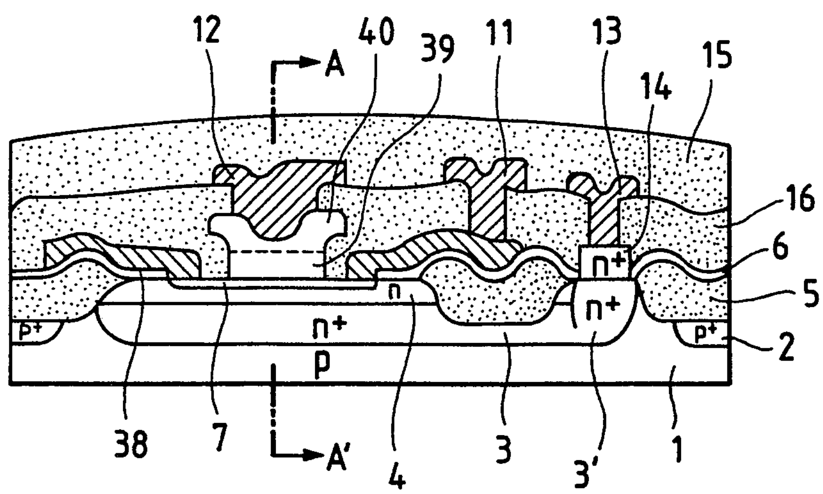


EP 0 390 606 A2

# Semiconductor Device Having Transistor Improved in Emitter Region and/or Base Electrode

## BACKGROUND OF THE INVENTION

### (1) Field of the Invention

This invention relates to a semiconductor device such as large scale integrated circuit (LSI) to be mounted on various electronic circuit devices, photoelectric converting devices, etc., particularly to a structure of a longitudinal type bipolar transistor of a semiconductor device.

### (2) Related Background Art

Presently, toward realization of ultra-high density LSI, researches and developments have been abundantly progressed. When electron injection region is made fine to the extent of 0.2 x 50 $\mu m^2$ by progress of fine working technique, for ensuring a current amount of 0.1 mA, development of a transistor which can drive an extremely high current density of $10^5 A/cm^2$ will be a key to realization of a ultra-high density LSI. Under such situation, a bipolar transistor of high current driving ability is extremely promising, and proposals of new structures have been made by aiming at shortening of the switching time and further improvement of driving ability.

For example, the switching time $t_{pc}$ when ECL (emitter couplet logic) circuit is assembled by use of a bipolar transistor is represented by the following formula:

$$t_{pd} \propto r_{bb'} [AC_{Tcl} + C_{dl}] + \frac{V_s}{I_{cs}} (C_{Tsl} + C_{del}] \quad (1)$$

where:
$r_{bb}'$: base resistance of input transistor
A: voltage amplification of current switch circuit

$$\simeq \frac{V_s}{4 \frac{RT}{8}}$$

$C_{Tcl}$: base collector junction capacity of input transistor
$C_{dl}$: diffusion capacity of input transistor and junction capacity between emitter and base
$V_s$: logic amplitude voltage
$I_{cs}$: current amount of input transistor
$C_{Tsl}$: parasitic capacity on the collector side of input transistor
$C_{del}$: diffusion capacity of output follower transistor.

As can be seen from the formula (1), in the low current region in the ECL current, that is when $I_{cs}$ is small, the delay time is determined by the collector response time of the second item in the formula (1), but in the region with large $I_{cs}$, the base response time becomes prevailing.

Thus, reduction of $r_{bb}'$, reduction of $C_{TC}$ and reduction of diffusion capacity, namely improvement of $f_T$ and reduction of junction capacity between emitter and base are the important points for higher speed.

In the prior art, for aiming at reduction of such base resistance, a transistor by use of SST (Super Self-aligned process Technology) has been proposed as shown in Fig. 1A. In Fig. 1A, 101 is a P substrate, 102 a device separation region which is a p+ layer effecting separation from the adjacent device, 103 a $n^+$ embedding layer, 104 a n-type epitaxial layer, 105 an oxidized film, 106 a $Si_3N_4$ film, 107 a p-type base layer, 107' its high concentration region, 108 an electrode portion comprising a $p^+$ polysilicon, 109 a $n^+$

emitter layer, 110 an emitter electrode comprising a $n^+$ polysilicon, 111, 112, 113 respectively metals for base, emitter collector electrodes.

114 is a collector electrode comprising a $n^+$ polysilicon and 115 an interlayer insulating film.

Thus, in the constitution in Fig. 1A, the base electrode 108 comprising $p^+$ type polysilicon is in contact with the base region 107′ in the vicinity of the emitter region.

Also, separately from this, in order to reduce the diffusion capacity, narrow the base width and also cover lowering in $h_{FE}$ (current amplification) corresponding to the base concentration elevation, a hetero-bipolar by use of a material with a wide band width as the emitter portion has been progressed.

However, of the capacity between base and emitter coupled to the base resistance ($r_{bb}'$), studies concerning reduction of the junction capacity component and investigation for solution thereof have not been progressed so far. Particularly, when the emitter size is made fine as 1 μm or less, of the junction capacity, the capacity at the flat plate portion becomes about 10%, while the capacity at the peripheral portion 90%, whereby contribution of the peripheral portion becomes overwhelmingly greater.

For reducing the capacity at the peripheral portion of the emitter base junction capacity, as shown by 201 in Fig. 1B, it is desirable to remove the diffusion region of the emitter layer into the base (109 in Fig. 1A), thereby making the interface between the emitter and the base flat.

However, even in such structure, the interface of the emitter with wide band width and the base material with narrow band width and the pn junction are coincident, whereby the recombined current at this interface becomes a great problem and no practical application has been successful.

On the other hand, the base electrode material according to the above-mentioned SST uses a polysilicon, and therefore the base resistance is still great as about 300 Ω, which has become a factor to control the switching speed. Further, although the base contact region of $p^+$ silicon is considerably approximate to the emitter region (ca. about 0.5 μm), as shown in Fig. 1A, the area for contact between the metal 111 for wiring and the $p^+$ silicon 108 is required, the device size itself cannot be miniaturized so much.

As described above, in the transistor of the prior art, no high speed actuation or high current amplification as required in recent years could be obtained.

## SUMMARY OF THE INVENTION

The present invention has been accomplished in view of the technical tasks as described above, and it is intended to provide a semiconductor device having an improved transistor capable of high speed actuation by reducing the base resistance, the base•collector junction capacity and the emitter•base junction capacity.

Another object of the present invention is to provide a semiconductor device having an improved transistor capable of obtaining high current amplification, in which of the capacities between base and emitter, the capacity component around the base•emitter junction is markedly reduced, and the recombined current at the base•emitter junction interface is markedly reduced to give high current amplification.

Still another object of the present invention is to provide a semiconductor device having an improved transistor capable of high speed actuation and giving high current amplification by forming suitably a desired region among the metal electrode, the collector region, the base region or the emitter region by use of the RF-DC combined bias sputtering method.

Still another object of the present invention is to provide a semiconductor device having an improved transistor capable of high speed actuation and giving high current amplification by incorporating impurities having conductivity at high concentration and with good controllability activated in the semiconductor region by performing epitaxial growth at low temperature during formation of the semiconductor region of the transistor.

Further, still another object of the present invention is to provide a semiconductor device having an improved transistor capable of higher speed actuation and giving high current amplification in which the energy band width is continuously varied with good controllability by varying the concentration of an inert gas during epitaxial growth at low temperature when forming the emitter region of the transistor.

Further, still another object of the present invention is to provide a semiconductor device having an improved transistor capable of high speed actuation and giving high current amplification by forming a single crystalline metal film having sufficient ohmic contact without heat treatment on a single crystalline semiconductor region.

BRIEF DESCRIPTION OF THE DRAWINGS

Fig. 1A is a schematic sectional view showing an example of bipolar transistor of the prior art;

Fig. 1B is a schematic sectional view showing the structure of another example of bipolar transistor of the prior art;

Fig. 2 is a schematic diagram for illustration of the RC-DC bias sputtering device for formation of the transistor according to the present invention;

Fig. 3 is a schematic sectional view showing one example of the bipolar transistor according to the first example of the present invention;

Fig. 4A is a schematic diagram for illustration of the bipolar transistor according to the present invention;

Figs. 4B and 4C are schematic diagrams for illustration of the bipolar transistor of the prior art;

Figs. 5A through 5K are schematic diagrams for illustration of the preparation steps of the bipolar transistor shown in Fig. 3;

Fig. 6 is a schematic sectional view showing an example of the bipolar transistor according to the second example of the present invention;

Fig. 7 is a schematic sectional view showing an example of the bipolar transistor according to the third example of the present invention;

Fig. 8 is a schematic sectional view showing an example of the bipolar transistor according to the fourth example of the present invention;

Figs. 9A through 9E are schematic sectional view for illustration of the preparation steps of the bipolar transistor shown in Fig. 8;

Fig. 10 is a schematic sectional view showing an example of the bipolar transistor according to the fifth example of the present invention;

Fig. 11A to Fig. 11C are schematic sectional views for illustration of the bipolar transistor shown in Fig. 10;

Fig. 12 is a schematic sectional view showing an example of the bipolar transistor according to the sixth example of the present invention;

Fig. 13 is a schematic sectional view showing an example of the bipolar transistor according to the seventh example of the present invention;

Fig. 14 is a schematic sectional view showing an example of the bipolar transistor according to the eighth example of the present invention;

Fig. 15A through Fig. 15G are schematic sectional views for illustration of the preparation steps of the bipolar transistor shown in Fig. 14;

Fig. 16 is a schematic sectional view showing a part of the photoelectric converting device utilizing the bipolar transistor according to the ninth example of the present invention;

Fig. 17 is a circuit diagram of the photoelectric converting device utilizing the bipolar transistor according to the ninth example of the present invention;

Fig. 18 is a timing chart diagram for illustration of the actuation of the photoelectric converting device utilizing the bipolar transistor according to the ninth example of the present invention;

Fig. 19 is a schematic sectional view showing the bipolar transistor according to the tenth example of the present invention;

Fig. 20 is a schematic sectional view showing the bipolar transistor according to the eleventh example of the present invention;

Fig. 21 is a schematic sectional view showing the bipolar transistor according to the twelfth example of the present invention;

Figs. 22A through 22I are schematic sectional views for illustration of the preparation steps of the bipolar transistor shown in Fig. 21;

Fig. 23 is a schematic sectional view showing the bipolar transistor according to the thirteenth example of the present invention;

Fig. 24 is a schematic sectional view showing the bipolar transistor according to the fourteenth example of the present invention;

Figs. 25A to 25C are schematic sectional views for illustration of the preparation steps of the bipolar transistor shown in Fig. 24;

Fig. 26 is a schematic sectional view showing the bipolar transistor according to the fifteenth example of the present invention;

Fig. 27 is a schematic sectional view showing the bipolar transistor according to the sixteenth example of the present invention;

Figs. 28A to 28C are schematic sectional views for illustration of the preparation steps of the bipolar transistor shown in Fig. 27;

Fig. 29 is a schematic sectional view showing the bipolar transistor according to the seventeenth example of the present invention;

Fig. 30 is a schematic sectional view showing the bipolar transistor according to the eighteenth example of the present invention;

Fig. 31 is a schematic sectional view showing the bipolar transistor according to the ninteenth example of the present invention;

Fig. 32A through Fig. 32G are schematic sectional views for illustration of the preparation steps of the bipolar transistor shown in Fig. 31;

Fig. 33 is a schematic sectional view showing the wiring portion of the semiconductor device according to the twentieth example of the present invention;

Fig. 34 is a schematic sectional view showing the wiring portion of the semiconductor device according to the twenty first example of the present invention;

Fig. 35 is a schematic sectional view showing the wiring portion of the semiconductor device according to the twenty second example of the present invention;

Fig. 36 is a schematic sectional view showing an example of the bipolar transistor according to the twenty third example of the present invention; and

Fig. 37 is a schematic sectional view showing an example of the bipolar transistor according to the twenty fourth example of the present invention.

## DETAILED DESCRIPTION OF THE PREFERRED EMBODIMENT

A preferable embodiment of the present invention is as described below.

It is a semiconductor device having a bipolar transistor having a collector region and an emitter region comprising a first electroconductive type semiconductor and a base region comprising a second electroconductive semiconductor different from the first electroconductive type, wherein the emitter region includes internally a region changed in energy band width, and the emitter•base junction is constituted of a substantially flat face.

The change in energy band width of the emitter region in the present invention should be preferably smaller on the emitter•base junction side, and a structure with the band width in the emitter region in contact with the base and the band width of the base region being substantially equal, and the band width in the emitter region apart from the base region being greater than the band width of the base region is more preferable.

The change in its band width may be stepwise or continuous, but more preferably, the layer thickness in the emitter region in contact with the base region is formed so as to be smaller than the diffusion length of a minority carrier. As the first electroconductive type semiconductor material forming the emitter region with the wide band width, semiconductor single substances of silicon, silicon carbide, silicon germanium carbide, galium arsenic, aluminum galium arsenic, etc. or semiconductors having distorted ultra-lattice structure of galium arsenic and aluminum galium arsenic, etc. may be suitably used.

Also, the emitter region has a structure in which the energy band width is changed by non-uniform distribution of the amount of inert element contained, or a structure in which the energy band width is changed by changing its crystal structure, or a structure in which semiconductor materials with different compositions are combined by utilizing the band widths inherent in the semiconductor materials.

Further, electroconductivity of the emitter region, even in the same first electroconductive type, should be preferably made a low impurity concentration region by reducing the content of the impurity on the base region side, while the region opposite to the base region a high impurity concentration region, thereby making the base•emitter capacity further smaller.

Another preferable embodiment for accomplishing the present invention is as described below.

It is a semiconductor device having a bipolar transistor having a collector region and an emitter region comprising a first electroconductive semiconductor and a base region comprising a second electroconductive type semiconductor different from the first electroconductive type, said transistor having a structure wherein the base electrode in contact with the base region is formed of a metal material and embedded in an insulating layer region.

The metal base electrode is provided not only on the base region, but may also have a constitution extended on the field insulating layer region adjacent to the base region. Alternatively, it may also have a constitution such that the base region is formed after formation of the base electrode to be provided only on the insulating region with its upper and side portions being in contact with the base region.

As the metal material constituting the base electrode Al, W, Mo, Cu, etc. can be used, but Al is preferable for simplification of the process and for providing products of high performance at sufficiently low cost to be commercially successful. Also, in the case of Al, it may also contain a small amount of Si, Ti or Cu.

Further, a more preferable embodiment for accomplishing the present invention is as described below.

It is a semiconductor device having a bipolar transistor having a collector region and an emitter region comprising a first electroconductive type semiconductor and a base region comprising a second electroconductive type semiconductor different from the first electroconductive type, said transistor having a structure wherein the emitter region includes internally a region where the energy width is changed, the emitterbase junction is constituted of a substantially flat face, and the base electrode in contact with the base region is formed of a metal material and embedded within an insulating layer region. The constitution of the emitter region, the constitution of the base electrode applicable to this embodiment are as described above, and therefore detailed description thereof is omitted here.

A preferable embodiment of the method for preparing the semiconductor device having the improved transistor according to the present invention is as described below.

That is, it forms the respective electrodes and/or the respective regions of collector, base and emitter by use of the RF-DC combined bias sputtering method.

Fig. 2 shows a preferable deposition film forming device for which such RF-CD combined bias sputtering method is applied.

This device activates constantly the surface by irradiation of ions with very small energy to the extent of junctioning energy of crystal (several eV to several 10 eV) onto the thin film surface during film formation, whereby the surface migration of deposited atoms can be accelerated to form a thin film with good crystallinity.

To the target 903 is connected, for example, a high frequency power source RF of 100 MHz through the combined circuit MC. By the high frequency power, the plasma density can be varied to control the amount of ions irradiated on the wafer 904.

Behind the target 903 is mounted a magnet 902, and stable high density plasma can be generated efficiently even under low gas pressure as the magnetron sputtering method.

The target 903 can be further connected to the direct current power source DC2 through low pass filter LPF to control the energy of the ions incident on the target, thereby controlling the deposition speed by changing the sputtering ratio.

In addition, also to the wafer holder 905 is connected a direct current power source DCl through low pass filter LPF, whereby the energy of the ions irradiated on the wafer 904 can be controlled.

GSS is a gas feeding system, including the gas source of Ar, etc. and flow rate controller. Further, a second gas feeding system for feeding gases of $H_2$, etc. may be also included.

VS is an evacuation system including an evacuation pump such as turbo molecular pump, cryo pump, etc.

The wafer holder 905 is made of SUS of the target 903, provided within the chamber 901 having a diameter of several 10 mm, and the distance between the target and the wafer is set within the range of several cm.

As the result of a large number of experiments repeated by the present inventors in order to produce a transistor of high performance by the RF-DC combined bias sputtering device, the following points were found.

1) Epitaxial growth of Si is rendered possible on a single crystal Si at low temperature (400°C or lower, more preferably 350°C or lower).

2) During the epitaxial growth of 1), n-type, p-type impurity of high concentration can be introduced, and these impurities are activated in the above-mentioned film forming process.

3) During the epitaxial growth of 1), by varying the concentration of an inert gas, the energy band width can be continuously varied.

4) Growth of a single crystal metal is possible on a single crystal Si.

5) The contact between the metal and the single crystal Si can give sufficient ohmic characteristic without heat treatment after film formation.

6) After formation of the above-mentioned embedded metal, epitaxial growth of Si is possible at low temperature (at 400°C or lower, more preferably 350°C or lower).

7) In 6), n-type, p-type impurity of high concentration can be introduced during epitaxial growth, and these impurities are activated during the above-mentioned film formation process. The present invention has been realized for the first time by the findings as mentioned above, and accomplished as the result of investigations and experiments in addition thereto.

The present invention exhibits further excellent actions and effects with the respective specific examples as described below, but the present invention is not limited at all to these examples, but any constitution which can accomplish the object of the present invention may be employed. In the respective examples, description is made particularly about the embedded base electrode structure which is the most characteristic constitution of the present invention.

[First example]

The first example of the present invention is described in detail by referring to Fig. 3. Fig. 3 is a schematic diagram showing the sectional structure of the bipolar transistor according to the first example of the present invention. In Fig. 3, 1 is a Si p-type substrate, 2 a $p^+$ layer for element separation, 3 a $n^+$ embedding layer for taking collector potential, 4 a n-type epitaxial layer which becomes the collector region, and the distance between the $p^+$ layer 7 and the $n^+$ embedded layer of epi-layer 3 is about 1000 to 3000 Å. Also, by the arising effect of impurities from the $n^+$ embedded layer 3 beneath the epi-layer 4, a slanted collector structure is realized to prevent lowering in speed by basewide ring. Here, the impurity in the epi-layer is $10^{16}$ to $10^{17}$ 1/cm$^3$.

5 is an insulating layer, and the shape having the birds peak shown in the Figure may be obtained by use of conventional selective oxidation technique. 3′ is a $n^+$ layer for effecting ohmic connection between the collector electrode 4 and the embedded layer 3. 7 is a base layer comprising a $p^+$ type semiconductor, the base concentration is $10^{17}$ to $10^{20}$ 1/cm$^3$, and for characteristic improvement of fr (frequency) the base width $W_B$ (layer thickness direction) is narrow as several 100 Å. 8 is the base electrode comprising the $p^+$ polysilicon of the base layer 7, 39 and 40 are $n^+$ Si thin films which become the emitter region, and the Si layer of 39 has a wide band width substantially equal to conventional single crystal Si, while 40 having a band width slightly wider than conventional single crystal Si. The impurity concentrations in 39 and 40 are high concentrations of $10^{20}$ to $10^{21}$ l/cm$^3$. With such constitution, between the Si layer region 39 and the Si layer region 40, a potential barrier for preventing reverse injection of positive holes is formed to improve the current amplification to great extent. The film thickness of the layer region 39 may be made the diffusion length of the positive layer or less. 16 is an interlayer insulating film, and conventional $SiO_2$, phosphorus doped glass, boron doped glass, boron-phosphorus doped glass, etc. can be used.

13 is a metal for collector wiring, which Al, AlSi, etc. 15 is a passivation film, and 6 is $Si_3N_4$ film. 11 is an Al film for base wiring and 12 an Al film for emitter wiring.

To summarize the different points of the bipolar transistor of the present invention from that of the prior art, they are as follows as can be seen from Fig. 3:

1) Emitter-base junction is flat with little recombination current at the interface.

2) Energy-band varied internally of the emitter thin film to form a barrier which prevents reverse injection of positive holes.

Simultaneous realization of these two points is described be referring to Figs. 4A to 4C. Fig. 4A shows schematically the blocked diagram of the constitution of the semiconductor layer when the transistor in Fig. 3 is cut along the line AA′, and for the purpose of reference the constitution of the hetero-bipolar transistor of the prior art is shown schematically blocked in Figs. 4B and 4C.

In Fig. 4A, the region 40 is a semiconductor layer with broad band width, the region 39 is a semiconductor layer with a band width narrower than the region 40. As shown in Fig. 4A, the bipolar transistor according to the present invention has emitter regions 40, 39 which are constituted of Si single crystal layers, while the base region 7, collector regions 4, 13 consist of epitaxial single crystals. Thus, the pn junction 41 of the emitter base is slipped from the junction interface 42, and because of junctioning with the same lattice constant and the same energy band width, the interface recombination current between the Si single crystal film and the single crystal portion is small.

Also, since the film thickness of the region 39 is sufficiently smaller than the diffusion length of positive hole, the potential barrier against positive hole formed at the interface with the region 40 is functioning sufficiently effectively.

On the other hand, in the case. of Fig. 4B, which is the constitution of a representative hetero-bipolar of the prior art, the pn junction interface 41′ between the emitter region 40′ and the base region 7 and the interface with the single crystal are coincident, whereby there is a problem that the recombination current is great.

For solving this problem, as shown in Fig. 4C, it may be conceivable to make a pn junction 41″ in the Si epitaxial region as shown in Fig. 4C, thereby assuming a structure in which the interface 42″ between the thin film and the single crystal epitaxial layer is slipped. However, the $n^+$ layer 39 in Fig. 4C is prepared by

the diffusion step, and therefore the above-mentioned pn junction face cannot be flattened similarly as described in the example in Fig. 1, to bring about increase of junctioning capacity.

The structure of this example has been accomplished on the basis of finding that a single crystal Si film can be grown at low temperature without including naturally oxidized layer, etc., and also n-type, p-type impurities are activated without requiring annealing by separate process.

As described above, the bipolar transistor of the present invention has the following advantages as compared with conventional ones:

1) base concentration can be increased so as to correspond to higher current amplification, and also base width can be made narrower;

2) emitter base junction is made to have a flat structure, thereby making its junctioning capacity smaller; and

3) also the recombination current occurring between the single crystal epitaxial layer and Si layer is small, etc.,

and can become a bipolar transistor with high speed and little noise component.

Next, the method for preparing the hetero-bipolar transistor according to the first example of the present invention is described by referring to Fig. 5. First, as the Si substrate as shown in Fig. 5A, a p-type high resistance substrate 1 was employed. First, photoresist working for formation of a collector embedding layer ($n^+$ BL) was performed by oxidizing the surface to effect selective etching of $SiO_2$ film as shown by 81 in Fig. 5A, followed by diffusion of n-type impurities of high concentration.

For the collector embedding layer 3, Sb with small diffusion constant was employed so that it could not be diffused by subsequent heat treatment, but because Sb is lower in solid solution degree to give a low resistance embedding layer, As, etc. may be also used. In this case, for prevention of redistribution of As, it is desirable that heat treatment should be made lower in temperature or autodoping prevention effected during epitaxial growth.

Next, by performing epitaxial growth as shown in Fig. 5B on the collector embedding layer, a n-type single crystal layer 4 was formed at about 1.0 to 0.8 $\mu$m and a concentration of $10^{15}$ - $10^{16}$ 1/cm$^3$. After the epitaxial growth, the surface was thinly oxidized as shown by 82 in Fig. 5B, and then a $Si_3N_4$ film 83 which becomes the mask for selective oxidation was formed by the CVD method.

Next, photoresist working for formation of a pattern for isolation was performed to effect etching of the $Si_3N_4/SiO_2$ film, and further etching of Si therebeneath. Such etching of the epitaxial layer 4 was effected to half of the epitaxial layer 4 so that the fixed face of the separated oxidized film contacted the collector embedding layer as shown by 84 in Fig. 5C.

Then for ensuring isolation, $B^+$ ion implantation element separation formation 2 for channel prevention was effected, and annealing for defect generation prevention was performed, followed by selective oxidation as shown in Fig. 5D. Selective oxidation, because the temperature is high as 900 to 1050 °C, was shortened in oxidation time by use of high pressure oxidation, so that no redistribution of the impurities in the collector embedding layer would occur. The $Si_3N_4$ film used for the mask of the selective oxidation was removed, and diffusion of phosphorus was effected in the collector take-out region as shown by 3′ in Fig. 5E.

Next, $Si_3N_4$ film 6 was deposited and further a polysilicon with no impurity added was formed thereon. The polysilicon at the unnecessary portions other than the emitter, the base and the collector regions was again selectively oxidized to form a polysilicon portion 85 and an oxidized layer 86 as shown in Fig. 5F. However, during the selective oxidation, the $Si_3N_4$ film employed remained only at the collector portion as shown by 87 in Fig. 5F.

Next, boron ions were injected into only the region where the polysilicon portion which becomes the base electrode is to be formed, and the $p^+$ polysilicon at the portions corresponding to the emitter and the base were removed to form a $p^+$ polysilicon 38 as shown in Fig. 5G.

Next, after oxidation of the surface of the $p^+$ polysilicon, the $Si_3N_4$ film was removed by etching. At this time, an appropriate amount of side etching was effected to form an overhang portion 88 as shown in Fig. 5H. Then, a part of the $SiO_2$ layer covering over the surface of the epitaxial 4 was removed by etching.

Next, a polysilicon without addition of impurity was formed, and wet etching was effected. Thus, the polysilicon was embedded as shown by 89 in Fig. 5I beneath the overhang portion of the $p^+$ polysilicon. Then, after formation of $SiO_2$ for protection of the emitter-base junction, a base region 7 was formed by injection of boron ions.

And, As ions are injected into the collector region shown by 14 in Fig. 51. Again, a polysilicon without impurity addition was formed, and this was removed by dry working having directionality, whereby the polysilicon as shown by 90 in Fig. 5I remained at the side face of the hole. With the polysilicon as the mask, $SiO_2$ was removed by dry etching to open a window 91 for emitter.

Next, the wafer was washed with $H_2SO_4$:$H_2O_2$ = 4:1 for 5 minutes, with water for 5 minutes and the

naturally oxidized layer removed with $HF:H_2O$ = 1:50, followed by repetition of the washing step of washing with water twice, to perform washing of the base surface of the window for emitter formation in Fig. 5I.

The wafer was placed in a RF-DC combined bias sputtering device, and Si films 39, 40 were formed to 4000 Å, followed by patterning by photoresist working. The film forming conditions of the Si films were as shown below.

As the Si target, a polycrystalline Si doped with 1 x $10^{21}$ l/$cm^3$ of As was employed, a DC bias -25V and a high frequency power of 100 MHz at 5W was applied on the Si target side, while a DC bias applied on the wafer side so that the surface potential became +7V, to perform first cleaning for minutes. The wafer temperature at this time was 300° C to 500° C.

After the above cleaning, with the wafer temperature being the same, the DC bias on the target side was elevated to -200V, and the above high frequency power to 40W, while the DC bias on the wafer side applied so that the surface potential became 5-10V, and film formation was effected to 100 to 500 Å, followed by gradual increase of Ar concentration by varying the flow rate of Ar which is the gas for sputtering so that the band width of Si could be expanded. By this, a barrier layer which prevents reverse injection of positive holes into the Si thin film which is the emitter electrode could be formed. The thin film of 100 to 500 Å as mentioned above is not limited to this value, but it may be smaller than the diffusion length of the positive hole.

After film formation as described above, the Si film was subjected to patterning to form an interlayer insulating layer 16 by the CVD device as shown in Fig. 5K. As the interlayer insulating layer 16, BPSG (boron phospho Silicate glass), PSG (phospho Silicate glass), NSG (non doped Silicate glass), etc. may be employed. Then, contact holes were opened, the metal for wiring was subjected to film formation patterning to form wirings 11, 12, 13 for base, emitter and collector, followed by formation of a passivation film 15.

As described above, the hetero-bipolar of the present invention is simplified as compared with the preparation steps of a transistor by use of conventional SST, and also has many advantages.

[Second example]

Next, the second example of the present invention is described by referring to Fig. 6. The same positions as in Example 1 are shown by the same symbols. The difference of this example from the first example is use of a fine crystalline silicon (μc-Si:H) as the material constituting the region 47 with wide energy band width internally of the emitter.

The method for forming the emitter regions 39, 47 is described below. Via a part of the preparation process similar to the first example, after opening of the window for emitter, the wafer was washed with $H_2SO_4:H_2O_2$ = 4:1 for 5 minutes, with water for 5 minutes and with $HF:H_2O$ = 1:50 to remove the naturally oxidized layer, followed by repetition of washing with water for 5 minutes twice, to effect the Si surface exposed on the window for emitter.

The wafer was placed in a RF-DC combined bias sputtering device, and initially cleaning treatment was performed with Ar ions. The conditions are the same as in the previous time.

Next, on a Si target doped with about 1 x $10^{21}$ l/$cm^3$ of As was applied a DC bias of -200V, a high frequency power of 40W, while the substrate temperature was made 350° C, biased so that the substrate surface voltage became 5 to 10V, to deposit a Si film to 100 to 500 Å, thereby forming a region 39. Then, while introducing hydrogen gas into the chamber, the substrate surface potential was dropped little by little by varying the bias voltage finally to the range of -15 to 0V. The Si film formed under this potential became to have a fine crystalline structure, with the Si board end being terminated with hydrogen, whereby the energy band width was expanded internally of the emitter region. Thus, a region 47 was formed. After formation of the emitter region, the device preparation may be performed according to the same steps as in the first example, and here the description is omitted.

Thus, by varying the substrate potential, the crystal structure of Si can be varied, whereby the band width can be easily varied.

[Third example]

Next, the third example of the present invention is described by referring to Fig. 7. The same positions as in the first example are shown by the same symbols. The difference of this example from the first example is use of a material different from Si as the region 48 with wider energy band width internally of the emitter region. As such material, there may be included distorted ultra-lattice structures of $Si_xC_y$,

$Si_xC_yGe_z$, GaAs, AlGaAs, GaAs-AlGaAs, etc.

The method for preparing the emitter region consisting of the two kinds of materials is described below. Similarly as in the first example, after washing of the Si surface of the window for emitter by the wet (with excessive small amount of sulfuric acid and dil. sulfuric acid) and dry (cleaning with Ar ions within the chamber) method, on a Si target doped with As about 1 x $10^{21}$ l/cm$^3$ was applied a DC bias of -200V, a high frequency power of 40W, while the substrate temperature was made 350°C and a bias was applied to the substrate surface potential of 5 to 10V to deposit Si to 100 to 500 Å, thereby forming a region 39. Then, a shutter was fallen between the target and the substrate, the target was changed to the above material with wide band width, and again film formation was commenced to form a region 48. During initiation of the film formation, again wafer surface washing with Ar ions may be also effected. Ordinarily, a material with wider band width than Si and Si differ in lattice constant and thermal expansion coefficient, and a large number of defects are generated at the junction interface. In the case of this example, by flowing hydrogen gas in the sputtering atmosphere, the defects can be compensated. Also, by making the values of x, y, z in $Si_xC_yGe_z$ desired values, it is possible to take matching of lattice constants. Also, by making the distorted ultra-lattice of GaAs-AlGaAs a structure sandwiched between the GaAs layers, the problem of these defects can be alleviated.

[Fourth example]

Next, the fourth example is described by referring to Fig. 8. The same positions as in the first example are shown by the same symbols. As contrasted to the first to third examples as described above, which employs a $p^+$ polycrystalline Si as the base electrode, in the fourth example, it consists of a metal electrode 50 embedded within an insulating layer 17. The insulating layer comprises specifically 5 and 18 as described below. By making such structure, the base resistance is lowered, whereby high speed characteristic of the bipolar transistor is further enhanced.

Also, in Fig. 8, 49 comprises a material with wider energy band width than Si, and various types as in the first example, the second example, the third example are available.

Next, the method for preparing the bipolar transistor of the fourth example is described by referring to Fig. 9. To the steps shown in Fig. 5D in the first example, the description of the preparation method is the same and therefore omitted.

After selective oxidation similarly conducted as shown in Fig. 5D, the $Si_3N_4$ film used as the mask for the selective oxidation was removed, and then phosphorus was diffused in the collector take-out region as shown by 3′ in Fig. 9A, and also ions of $B^+$ were injected into the base region to form a base region 7.

Next, until the Si surface for the base region and the collector take-out region could be formed, a part of the $SiO_2$ layer 5 was removed by etching. As the etchant, for example, an etchant of $HF:H_2O$ = 1:50 or $NH_4F:H_2O$ = 1:10, etc. may be employed.

Next, the wafer was washed with $H_2SO_4:H_2O_2$ = 4:1 for 5 minutes, with water for 5 minutes and with $HF:H_2O$ = 1:50 to remove the naturally oxidized layer, followed by repetition of washing with water for 5 minutes twice.

Next, as shown in Fig. 9B, the Al film 50 was formed to 2000 to 6000 Å by a RF-DC combined bias sputtering device. The film formation conditions are as shown below. With the background vacuum degree being made 1 x $10^{-10}$ torr, Ar gas of 3 mtorr was introduced into the chamber, and then a DC bias of -20V and a high frequency power of 100 MHz were applied at 5W on the Al target side, while a DC bias was applied to the surface potential of +10V, followed by leaving to stand for 5 minutes. By this, cleaning of the wafer surface was effected within the chamber. Then, the DC bias on the target side was increased to -200V, and the above high frequency power to 80W, while the surface voltage of the wafer to -20V by control of the bias voltage to effect film formation of Al. After Al film formation, patterning was performed by photoresist working on the above Al film as shown by 50 in Fig. 9C, to form a $SiO_2$ layer 18 by CVD. After film formation of $SiO_2$ layer 18, the $SiO_2$ layer on the region which becomes emitter and collector is removed by etching. Thus, the base electrode 50 of Al was embedded with the insulating layer.

Next, the wafer was washed with $H_2SO_4:H_2O_2$ = 4:1 for 5 minutes, with water for 5 minutes and with $HF:H_2O$ = 1:50 to remove the naturally oxidized layer, followed by repetition of washing with water for 5 minutes twice, thus performing washing of the wafer surface. The wafer was placed in a RF-DC combined bias sputtering device, and regions 39, 49 for forming the emitter were formed into films of 4000 Å, followed by patterning by photoresist working. The regions 39 and 49 are single crystalline Si films in the vicinity of the interface with the base as shown in the first to third examples as described above, and their upper portions are constituted of thin films with wider band width than the Si film.

Next, as shown in Fig. 9E, the interlayer insulating film 16 for forming the emitter region 49 and the contact hole was formed by CVD, etc., and then the hole 58 for contact was formed by resist working in the emitter and the collector electrode region. After formation, the emitter electrode 12 of Al and the collector electrode 13 of Al were formed by patterning by the RF-DC crystal bias sputtering device used previously, and then a passivation film 15 was formed.

As described above, the base resistance is lowered by use of a metal as the base take-out electrode 50. After film formation of the metal, formation of an insulating layer and film formation of an emitter region are performed, and the substrate temperature during these film formation steps may be sufficiently 400 °C, having no influence on the metal film as the base electrode.

The structure according to this example could be accomplished by developments of the following techniques:

1) when a metal film is formed on Si, after the film formation, good electrical contact can be obtained without heat treatment;

2) when epitaxial growth of Si is performed on Si, it can be realized at a low temperature of 400 °C or lower, specifically 350 °C or lower.

[Fifth example]

Next, the fifth example is described by referring to Fig. 10. The same positions are described with the use of the same symbols. The specific feature of this example resides in the point that the metal film 61 as the base electrode is located beneath the thin film base layer 62. The advantage of this structure is that the parasitic capacity component other than the semiconductor junction capacity of the emitter base can be reduced, because the base electrode 61 of the base electrodes is surrounded with a thick insulating layer at the portions other than the portion in contact with the thin film base layer 62. Further, even if spikes may be generated from the embedded base electrode, no leak will be generated thereby to give no deleterious influence on the characteristics of the device, whereby the yield can be improved.

Next, the method for preparing the device of the fifth example is described briefly by referring to Fig. 11. As shown in Fig. 11A, on the field oxidized film 5 was formed an Al film according to the sputtering method by use of a RF-DC combined bias sputtering device, and patterning shown by 61 was effected by photoresist working. Next, the base layer was formed by a RF-DC combined bias sputtering device, followed by patterning as shown by 62 in Fig. 11B. After formation of the base layer 62, as shown in Fig. 11C, an insulating layer 18 was formed by the CVD method, and holes were opened by resist working in the emitter region and the collector region. After hole opening, the emitter layer was formed by a RF-DC combined bias sputtering device, followed by patterning as shown by 65 in Fig. 11C. Of course, here the emitter region 65 includes the region having the wide band width by use of the material as described above.

[Sixth example]

Next, the sixth example of the present invention is described by referring to Fig. 12. The same positions as in the first example as described above are shown by the same symbols. The specific feature of this example, as can be seen from Fig. 12, is that the wall 66 of the insulating film 67 in the vicinity of the base-collector junction is substantially vertical so as to cross the base-collector surface as compared with the structure of the fifth example, and the base-collector junction surface is flattened. Also, the interface between the epi-layer 4 and the embedding layer 3 is flattened. From these facts, the base-collector junctioning capacity is reduced to accomplish higher speed of the transistor. Up to the fifth example as described above, a field insulating film having birds peak was employed, but the present example was realized by forming the collector region by epitaxial growth, then cutting a groove vertically by RIE (Reactive Ion Etching) technique, and placing the wafer in a CVD device to deposit silicon oxide sufficiently, thereby forming an insulating film to be flattened, followed by etching to the surface.

[Seventh example]

Next, the seventh example is described by referring to Fig. 13. The positions as in the above sixth example are shown by the same symbols. The specific feature of this example, as can be seen from Fig.

13, resides in the point that the structure is made by use of a substrate 68 comprising a $p^+$ type Si semiconductor and a $p^-$ layer 69 is provided between the $n^+$ embedding layer 3.

The effect with such constitution is now described. When there is no $p^-$ layer 69, if great current is momentarily flowed through the bipolar transistor, the potential of the collector layer will be fluctuated. Since a reverse bias is applied for device separation between the $n^+$ embedding layer 3 which determines substantially collector potential and the p substrate, and a depletion layer is formed therebetween. The depletion layer will not respond momentarily to the applied voltage as the actuation frequency becomes higher, whereby time delay occurs. The time constant is dictated by the capacity C which is determined by the whole resistance R and the depletion layer width of the p substrate. Therefore, if the substrate resistance is large, it will affect greatly the switching speed of the bipolar. Accordingly, as the result of overall investigation, the width of p- layer has been determined by using a highly concentrated substrate and forming a p-layer between the $n^+$ embedding layer so as to make the time constant of the above-mentioned RC small. As described above, in this example, there is the advantage of preventing lowering in switching speed by the depletion layer response on the substrate side.

Next, the method for preparation of the transistor according to this example is briefly described.

Basically, the methods for forming the respective regions of collector, base, emitter, respective insulating films and respective electrodes are the same as in the foregoing examples, and therefore only the characteristic portion of this example is described.

First, a $p^+$ single crystalline Si substrate 68 of high impurity concentration is prepared, and a $p^-$ layer 69 doped with minute amount of B is epitaxially grown thereon. Into the region where the device separation is to be formed is injected ions of B. Then, $n^+$ embedding layer 3 is formed by diffusion of As, and further the collector region 4 is formed by epitaxial growth. Then, the region where the field insulating film is to be formed is etched by RIE. So as to embed the concavity, silicon oxide is deposited by the CVD method, followed by etch back to form a flat surface. Subsequent process is as described above.

[Eighth example]

Next, the eighth example of the present invention is described by referring to Fig. 14. In Fig. 14, 301 is the $p^+$ layer of the Si p substrate, 310 the $p^-$ layer, 302 the $p^+$ layer for device separation, 303 the $n^+$ embedding layer, 380 the metal embedding which becomes the collector electrode surrounded by the above $n^+$ embedding layer, 304 the n-type epitaxial layer which becomes the collector region, with the vicinity of the interface with the metal layer 380 therebeneath being $n^+$ layer. 382 is the insulating layer provided around the above-mentioned collector region 304, 361 the embedding base electrode, 362 the extremely thin $p^+$ base electrode which is about 100 Å similarly as in the first example. 339, 340 are emitter regions, 312, 313 are respectively metal wirings for emitter, collector electrodes, 316, 318 are interlayer insulating layers, and 315 is a passivation film. As can be seen from Fig. 14, in the eighth example, a metal is employed in place of conventional $n^+$ embedding layer as the embedding layer for setting collector potential. By this, the collector resistance becomes extremely lower, whereby a transistor with high driving ability and also capable of high speed actuation can be accomplished without anxiety of fluctuation of collector potential even during great current actuation.

Next, the preparation method of the present eighth example is described referring to Fig. 15. As shown in Fig. 15A, $p^+$ layer 301 is formed at the whole back surface of the p substrate 310 and $p^+$ layer 302 is formed in the device separation region.

Next, in the device separation region, $SiO_2$ layer 90 is provided on the above wafer surface shown in Fig. 15B, and anisotropic etching is effected by use of this as the mask. As the etchant, KOH:isopropyl alcohol = 4:1 solution, etc. may be employed. After etching, by utilizing the $SiO_2$ mask, As implantation was effected. At this time, after formation of a thermally oxidized film on the wafer surface, implantation may be effected. After implantation, annealing was carried out in a $N_2$ atmosphere of 900 °C to activate the As implanted.

Next, the $SiO_2$ layer 90 on the wafer surface was removed by etching, and so that Si surface without naturally oxidized film could be formed, washing was conducted with $H_2SO_4$:$H_2O_2$ = 4:1 for 5 minutes, with water for 5 minutes, with HF:$H_2O$ = 1:50 for 20 seconds, with water for 5 minutes repeated twice.

The washed wafer was placed in a RF-DC combined type bias sputtering device for Al film formation, and film formation of Al was effected shown by 91 in Fig. 15C to the region where the groove formed by anisotropic etching was embedded. However, cleaning of the wafer surface with Ar ions before film formation was performed similarly as in the first example.

As shown in Fig. 15C, when Al film formation is effected by means of this device, the shape becomes

naturally to flatten the step difference. This may be considered because the edge regions of the groove is more susceptible to sputtering. Subsequently, the wafer was placed in a RF-DC combined type bias sputtering device for formation of Si film to provide an epitaxial layer 92 thereon. The above Al film is crystallized, and therefore Si also becomes an epi-film. The film forming conditions are the same as in the first example, and therefore the description is omitted. The concentration of the epi-layer is $10^{16}$ to $10^{17}$ l/cm$^3$, and for obtaining good contact with the metal layer, a polycrystalline Si target doped with 1 x $10^{21}$ l/cm$^3$ of As was used, and thereafter the target was changed over to give a desired epi-concentration. By formation of the epi-layer according to this method, there are the advantages of good control pressures of epi-film thickness and epi-concentration. Thus, after film formation of the metal film 91 and the epi-layer 92, the surface was etched uniformly so as to form the epi-layer to 1000 Å and yet have the embedded metal and the $p^+$ for device separation exposed on the surface. The wafer was further subjected to etching to provide a groove shown by 93 around the region where the emitter of the bipolar is to be formed as shown in Fig. 15D. The depth of the groove is set shallower than the metal film 380 and deeper than the epi-layer 304. On the wafer surface having formed the groove 93 thereon was formed an insulating layer by the CVD method, and again etching was effected until the surface of the epi-layer 304 was exposed, thus embedding the insulating layer in the groove 93 to make the surface flat. In formation of the flattened insulating layer 382, the bias ECR method, the liquid phase CVD method, etc. can be also used.

Next, the wafer was placed in a RF-DC combined bias sputtering device for Al film formation, and a metal film for embedding base electrode was formed. After film formation, the insulating layer 382 embedded in the groove 93 was subjected to patterning to form the base electrode 361 thereon as shown in Fig. 15E. After formation of the base electrode 361, the base layer 362 shown in Fig. 15F was formed by use of a RF-DC combined bias sputtering device for Si film formation. After formation of the base layer 362, an interlayer insulating layer 318 was formed a hole was opened at the portion where an emitter was to be formed to deposit Si. The single crystalline Si was patterned.

Thus, emitter regions 339 and 340 were formed. These regions 339 and 340 have respectively different band widths, and the details are the same as described in the first to the third examples.

After formation of the emitter region 340, the insulating film 316 was formed and a contact hole for taking contact of the emitter was formed by etching. Similarly, a thru-hole was formed in order to take contact with the collector electrode 380.

Next, by depositing Al and effecting patterning, the emitter electrode 312 and the collector wiring 313 were formed.

And, the passivation film 315 was formed to form the bipolar transistor.

As described above, by forming a metal film by a RF-DC combined bias sputtering device, its metal is single crystal and a single crystalline Si can be grown on the single crystalline metal at low temperature, whereby the structure of the present invention could be accomplished.

In this example, the film of a metal was formed on a Si substrate, and a device formed thereon, but the device of this example can be formed on a metal substrate as a matter of course.

[Ninth example]

Next, the ninth example of the present invention is described by referring to Fig. 16. The first to the eighth examples as described above have the technique of the present invention applied to high speed bipolar transistor, but the present ninth example is an application to a photoelectric converting device, and Fig. 16 is a schematic sectional view of the sensor element of one picture element of the above device. In Fig. 16, 401 is a p-type Si substrate, but it may be also a n-type. 403 is a n-type embedding layer, 404 a $n^-$-type epitaxial layer, with its concentration and thickness being determined depending on what the peak value of spectral sensitivity is set, but for bringing the center of sensitivity in ordinary visible light region, the concentration may be made 3 x $10^{14}$ to $10^{15}$ l/cm$^3$, and the thickness about 5 $\mu$m. 402 is a n+ layer for separation between the respective picture elements, 405 a field oxidized film which can be formed by the selective oxidation method similarly as in preparation of the high speed bipolar of the first example. 407 is a p-type base layer, and the emitter portion is constituted of 439 and 440, 439 being a $n^+$ Si single crystalline film and 440 being $n^+$ and yet a film with wider energy band width than the above 439. 418, 416 are interlayer insulating layers, and NSG, BPSG, PSG, etc. can be used therefor. 412 is an emitter electrode, which may be constituted of, for example, Al, Al-Si, etc. 420 is a light shielding layer, and 415 is a passivation film.

Next, the actuation of the present photoelectric converting device is briefly described. As shown in Fig. 16, the information light 474 enters through the region 475 not covered with the light shielding layer 420

internally of the semiconductor. At this time, the potential of the $n^+$ embedding layer 403 is biased to become 5V, and the base layer 407 is under the floating state at a potential lower than the above $n^+$ embedding layer 403, for example about 1V.

Therefore the epitaxial layer 404 between the base layer 407 and the embedding layer 403 is deplenished. If the information light 474 enters the semiconductor region, electron-positive pairs are generated, but since the epitaxial layer 404 is deplenished and the positive layers flow into the base layer 407 by the electrical field generated there and the electrons into the $n^+$ embedding layer 403. Since the above-mentioned base layer is under the floating state, positive holes are accumulated corresponding the incident light dose to elevate the potential of the above-mentioned base layer 407. Accordingly, when the transistor constituted of the emitters comprising 439, 440, the base 407, the collectors 404, 401 becomes the ON state, the potential change of the emitter corresponding to the above-mentioned base layer potential can be read. That is, if a capacity $C_T$ for reading is provided on the wiring 412, the signal charge corresponding to the above light dose can be read at this capacity.

Fig. 17 shows the circuit diagram of the photoelectric converting device according to this example.

Fig. 17 is described by referring to an example of a photoelectric converting element array having 48 photoelectric converting elements arranged in an array.

Each photoelectric converting element is constituted of a light receiving transistor (S1-S48), a PMOS transistor for base reset (QP1-QP48), a NMOS transistor for emitter reset (QN11-QN14B), a NMOS transistor for comprehensive transfer (QN21QN248), a capacity element (CT1-CT48) and a NMOS transistor for successive transfer (QN31-QN348).

SRI is a shift resistor as the scanning circuit which generates the signal for scanning successively the transistor for successive transfer.

QNH is a NMOS transistor for line reset for resetting the common line CL1, and AM is an amplifier.

Further, $V_{BB}$ is a standard power source for base reset, PSE a standard for emitter reset, and here it is earth potential.

Referring now to Fig. 17, Fig. 18, the actuation of the photoelectric converting device including reset, accumulation, reading actuations is described.

(Reset actuation)

First, in order to make the base potential of the respective light receiving transistors constant, a negative pulse is inputted at the terminal ΦBRS to turn on the PMOS transistor (QP1-QP48) (clamp reset). Simultaneously with turn-off of the PMOS transistor, a positive pulse is applied on the terminal ΦERS to turn on the NMOS transistor (QN11-QN148) (transient rest), and at the same time positive pulse is applied on the terminal ΦT. Thus, reset can be effected by combining the positive hole as the residual charge accumulated in the base of the light transistor of each element with the electron through the base and the emitter. At this time, the reading line and the capacity element (CT1-CT48) are also reset.

(Accumulation, reading actuation)

When the NMOS transistors (QN11-QN148 and QN21-QN248) become the off-state, the base and the emitter of the light receiving transistor are made floating state. Under this state, primarily in the depletion layer between the base and the collector, etc., electron•positive hole pairs are formed corresponding to the incident light, and among them, electrons are withdrawn toward the collector side biased at a constant potential, but the positive holes are accumulated to elevate the base potential. Following the change in base potential, the potential of the emitter is also changed. Thus, the optical signal is accumulated as the signal charge which is the parasitic capacity of the reading line (CE1-CE48).

The signal charge accumulated is transferred to the capacity element (CT1-CT48) by application again of the positive pulse on ΦT (see $V_{CT}$(SI)). And, positive pulses are outputted from the output terminals (SRG1-SRG48) of the shift resistor SR1 to scan successively the transfer transistors (QN31-QN348), to be outputted with amplification by the amplifier AM through the common line CL1. Between scanning of the respective elements, the line reset transistor QNH is turned on to reset the common line CL1.

As described above, by repeating the actuations of reset•actuation•reading, optical information can be read. And, non-destructive reading and reading simultaneous with accumulation are also possible. In addition, it has high sensitivity and high S/N.

Details of the basic constitution of the photoelectric converting devices are described in USP 4,791,469

Ohmi et al and USP 4,810,896 Tanaka et al.

In this example, by improving the emitter region and the emitter•junction region of the light receiving transistor as described above, further higher driving and higher current amplification can be obtained.

The factors determining such characteristics are described below. When the emitter earth amplification is defined as $h_{FE}$, and the total capacity of the base region as $C_B$, the ratio $\eta$ of the positive holes which are accumulated in the base region destroyed by the reading actuation of signal becomes approximately:

$$\eta \simeq \frac{C_T}{h_{FE}C_B + C_T} \qquad (1)$$

Thus, the $h_{FE}$ which tries to read correctly without destroying the charges generated by photoirradiation so far as possible should be preferably higher. According to the transistor having the emitter structure of the present invention, since a barrier layer for reverse injection prevention of positive holes was formed internally of the emitter, good characteristics were obtained. Also, the interfacial recombination between the emitter thin film and the base film which becomes the problem in ordinary hetero-bipolar was extremely small, posing no problem.

Also, the photoelectric converting device of this type has a structure having a transistor per one picture element as described above, and there is a fear that variance may occur between very small picture elements, even though variance can be inhibited by clamping of the base potential. This variance amount is marked when $h_{FE}$ is very large as in the above hetero-bipolar transistor, and is reduced as the $Z_f$ value shown by (2) is smaller.

$$Z_f \simeq 1 + \frac{C_E}{C_B} \qquad (2)$$

In the formula $C_E$ is the capacity between the base and emitter.

In the photoelectric converting device of this example:

1) the junction of base•emitter is flattened, whereby the junction capacity is made the minimum value;

2) the diffusion capacity between base and emitter is narrowed in base width corresponding to high $h_{FE}$ value, and minimumization is also possible concerning this.

Accordingly, variance between the respective picture elements is extremely small, whereby a photoelectric converting device of further higher sensitivity and lower noise can be realized.

[Tenth example]

Next, the tenth example is described by referring to Fig. 19. The same positions as in the sixth example are marked with the same symbols and description is omitted. In the tenth example, between the $n^+$ layer 40 having wider band width than Si and the base layer 62, a n-layer 201 with lower concentration than in the above $n^+$ layer 40 is provided. The thickness of the layer 201 is made sufficiently shorter than the diffusion length of hole, and similar to or broader than the base•emitter deplenished width. Specifically, for example, by use of the present structure of 1 x $10^{18}$ $cm^{-3}$, width 100 Å, junctioning mutually between high concentrations of the emitter layer and the base layer can be avoided, whereby not only tunnel current can be inhibited, but also the above-mentioned junctioning capacity can be reduced and further higher speed can be accomplished. This example has taken up the structure of the sixth example, but this structure is not particularly limitative, but also in other examples, it is preferable to provide a low concentration layer with the same band width as the base layer between the wide band width $n^+$ layer and the base layer.

[Eleventh example]

Next, the eleventh example of the present invention is described by referring to Fig. 20. The same positions as in the tenth example are marked with the same symbols, and description is omitted. The difference of the eleventh example from the tenth example is the point of the structure of covering the base electrode portion 61 completely with the base layer 202. By making this structure, there will be no resist peel-off after patterning of the base layer 202, and restriction accompanied with Al exposure during washing step, whereby there is the advantage that it can be formed according to conventional steps.

In the respective examples as described above, by providing a region with varied energy band width

internally of the emitter thin film region, and also making the emitter•base junction a flattened structure, there are the following effects:
the recombined current occurring at the emitter•base interface can be made smaller;
the capacity between emitter and base can be minimized;
the emitter located current amplification can be increased.

Thus, when the bipolar transistor is made higher in speed and a photoelectric converting device is prepared, improvement of its sensitivity, and higher S/N ratio due to reduction of noise can be effected.

[Twelfth example]

This example is described in detail by referring to Fig. 21. Fig. 21 shows schematically a sectional structure of the bipolar transistor of the twelfth example of the present invention. In Fig. 21, 501 is a p-type Si substrate, 502 a $p^+$ layer for device separation, 503 a $n^+$ embedding layer of low resistance for taking the potential of collector, 508 an embedding metal for base electrode as the electroconductive member, for example, preferably Al, Cu, etc. 505 is an insulating layer comprising $SiO_2$, and the shape as shown by 505 may be obtained by use of conventional selective oxidation technique. 504 is a n-type layer constituting the collector region epitaxially grown (epi-layer), with the base region of the transistor between the $p^+$ base layer 507 and the $n^+$ embedding layer 503 being about 1000 Å. Also, by the arising effect of impurities of the $n^+$ embedding layer 503 beneath the epi-layer 504, a slanted collector structure is realized to prevent lowering in speed by basewide ring. As the impurity concentration in the epilayer 504, $10^{15}$ to $10^{17}$ l/cm$^3$ is preferred. 506 is a $n^+$ layer for connecting the collector electrode and the embedding layer 503 with electrically low resistance. Since the above $n^+$ layer 506 can be formed with the field oxidized layer as the mask during ion injection, its size can be made fine, and yet variance between the collector contact with the respective elements is little. A preferable impurity in the $p^+$ base layer 507 may be $10^{17}$ to $10^{19}$ l/cm$^3$, and for characteristic improvement of fr (frequency), the base width $W_B$ is made narrow as several 100 Å. Since ion injection during formation of the base layer 507 can be also effected with the field oxidized layer as the mask, fine formation of the base region and stabilization of the size are effected. 509 and 510 are $n^+$ type Si layers, 509 being a $n^+$ Si layer for emitter electrode and 510 a $n^+$ Si layer for collector electrode. The impurity concentrations in 509, 510 are as high as $10^{20}$ to $10^{21}$ l/cm$^3$, and yet since they are single crystals, the resistance values at the electrode portions of emitter and collector are extremely small and stable. 511, 512 are respectively metal films for wiring of emitter and collector, and 513 a passivation film.

The semiconductor device of the twelfth example, as can be also seen from Fig. 21, has the following characteristics:

(1) the base electrode 508 is formed of a metal, and the base resistance is reduced;

(2) the base electrode 508 is not required to be in contact with the wiring, whereby the transistor size can be reduced;

(3) the emitter•base junction is formed at a flat face, and the junction capacity between emitter and base is also minimized;

(4) due to the effect of arising effect of impurities from the $n^+$ embedding layer 503 to the epi-layer 504, the structure becomes a slanted collector structure, whereby basewide ring can be prevented.

Next, the method for preparing the bipolar transistor of the twelfth example as described above is described by referring to Fig. 22. First, as shown in Fig. 22A, for the substrate Si was prepared a p-type high resistance Si substrate 521. By first oxidizing the surface, photoresist working for formation of a collector embedding layer ($n^+$ BL) was performed, and after selective etching of $SiO_2$ film as shown by 522 in Fig. 22A, the impurities of atoms belonging to the group V of the periodic table were diffused to high concentration. As the impurity preferable in this case is Sb which is small in diffusion constant so that it will not be spread by subsequent heat treatment.

Alternatively, since Sb is low in solid solution degree, As, etc. may be also employed. In this case, for prevention of redistribution of As, the heat treatment is made lower or autodoping prevention during epitaxial growth is effected.

Next, on the collector embedding layer 523 is performed epitaxial growth as shown by 524 in Fig. 22B to form a n-type single crystal layer to about 1.0 to 0.8 μm with an impurity concentration of $10^{15}$ to $10^{16}$ l/cm$^3$. After the epitaxial growth, the surface was thinly oxidized as shown by 525 in Fig. 22B, and then $Si_3N_4$ film 526 which becomes the mask for selective oxidation was formed by the CVD method.

Next, photoresist working for isolation pattern formation was performed to etch partially the $Si_3N_4/SiO_2$ film, followed further by etching of Si. The etching of Si was performed to half of the epitaxial layer 527 so that the bottom of the oxidized film for device separation as shown in Fig. 22C was in contact with the

collector embedding layer.

Then, for ensuring device separation, ion implantation of $B^+$ for channel prevention was effected, and after annealing for prevention of defect generation, selective oxidation was performed as shown in Fig. 22D to constitute the device separation region comprising the $p^+$ region 528 and the oxidized film. Since selective oxidation was performed at a high temperature of 900 to 1050°C, the oxidation time was shortened by use of high pressure oxidation so that no redistribution of the impurities in the collector embedding occurred.

The $Si_3N_4$ film used for the mask of selective oxidation was removed, and in the collector take-out region, as shown in Fig. 22E, a $n^+$ region 529 with low resistance was formed by diffusion of phosphorus as the take-out region of collector potential, and also ion injection of $B^+$ was effected into the base region to form a base region 530.

Next, the $SiO_2$ layer is removed by etching until the Si surface of the base region and the collector potential take-out region is exposed. The etchant used may be, for example, an etchant of $HF:H_2O$ = 1:50, $NH_4F:H_2O$ = 1:10, etc.

Next, the wafer was washed with $H_2SO_4:H_2O_2$ = 4:1 for 5 minutes, with water for 5 minutes, and with $HF:H_2O$ = 1:50 to remove the naturally oxidized layer, followed by repetition of washing with water for 5 minutes twice.

Next, as shown in Fig. 22F, an Al film 31 was formed by a RF-DC combined bias sputtering device to 2000 to 6000 Å. The film forming conditions are as follows. With the background vacuum degree being made $1 \times 10^{-10}$ torr, after introduction of 3m torr of Ar gas into the chamber, DC bias of -20V, a high frequency power of 100 MHz at 5W were applied on the Al target side, while on the wafer side was applied a DC bias to make the substrate surface potential +10V, followed by leaving to stand for 5 minutes. By this, cleaning of the wafer surface is effected within the chamber. Then, the DC bias on the target side was elevated to -200V, and the above-mentioned high frequency power to 80W, while the surface voltage on the wafer side made -20V, to perform film formation of Al film.

And, after Al film formation, as shown by 532 in Fig. 22G, metal was subjected to patterning as an electroconductive member which is contacted well electrically with the base region and also functions as a wiring by photoresist working, etching of the above-mentioned Al film.

$SiO_2$ film layer 533 was formed by CVD. After film formation, the above-mentioned $SiO_2$ layer 533 which becomes the region of the emitter portion and the collector portion was removed by etching.

Next, after the wafer was washed with $H_2SO_4:H_2O_2$ = 4:1 for 5 minutes, with water for 5 minutes, with $HF:H_2O$ = 1:50 to remove the naturally oxidized layer, the steps of washing water for 5 minutes were repeated twice, to effect washing of the wafer surface. The wafer was placed in a RF-DC combined bias sputtering device to form a Si film 534 to 4000 Å, followed by patterning by photoresist working. The film forming conditions of the above Si film are as follows.

As the Si target, a polycrystalline Si doped with As to about $1 \times 10^{21}$ $l/cm^2$ was employed, and a DC bias of -25 V and a high frequency power of 100 MHz at 5 W were applied, while on the wafer side was applied a DC bias to make the substrate surface potential + 7V. Cleaning of the above wafer surface was performed for 5 minutes. After the cleaning treatment, the DC bias on the target side was elevated to - 200 V, and the above high frequency power to 40 W, while the surface potential on the wafer side was made + 5 to + 10 V, to effect film formation of Si film. As the wafer temperature, it may be in the region of 300 °C to 400 °C, without having any influence on the Al film 32 in the previous step.

Next, as shown in Fig. 22I, after formation of an interlayer insulating film 35 by CVD, etc., a hole 36 for contact was formed by resist working at the emitter and collector electrode regions. After formation, by the previous Rf-DC combined bias sputtering device, an Al electrode 537 was attached, and after patterning, a passivation film 538 was attached.

As described above, a metal is employed as the take-out electrode of base potential, whereby base resistance is reduced. After film formation of the metal, film formation of insulating layer and Si are perfomed, and during such film formation, the substrate temperature is 400 °C or lower, preferably 350 °C or lower, which has no influence on the base electrode material. This structure has been accomplished as the result of realizing a film formation method which can effect epitaxial growth on Si even at a low temperature in the vicinity of 350 °C, and finding that good contact can be taken when a metal film was formed on Si without heat treatment after film formation.

(Thirteenth example)

Next, the thirteenth example is described in detail by referring to Fig. 23. The same positions as in the

twelfth example are marked with the same symbols. The difference of this example from the twelfth example is that the film 539 of the emitter region, etc. of the thirteenth example comprises a fine crystalline silicon (uC-Si) as non-single crystal material, as contrasted to the Si films 509, 510 which are single crystal films. The film forming conditions of the above-mentioned 539 are as follows.

Similarly as in the twelfth example, the wafer subjected to etching of the $SiO_2$ layer in the region corresponding to the emitter region and the collector region was washed with $H_2SO_4:H_2O_2=4:1$ for 5 minutes, with water for 5 minutes, with $HF:H_2O=1:50$ to remove the naturally oxidized layer on the Si surface at the emitter portion and the collector portion, followed further by washing with water for 5 minutes, and these series of steps were repeated twice to wash the wafer surface. The wafer was placed in a RF-DC combined bias sputtering device of a background vacuum degree of $1 \times 10^{-10}$ torr, and 3 m torr of Ar gas was introduced into the chamber. Then, a DC bias of - 25V and a high frequency power of 100 MHz at 5 W were applied on the target side, while on the wafer side was applied a DC bias to make the substrate surface + 7V, to effect cleaning of the wafer surface with plasma for 5 minutes. After the cleaning treatment, DC bias was elevated to - 200 V and the high frequency power to 40 W on the target side, while the surface voltage on the wafer side made within the range from - 15 to 0 V, to carry out film formation of Si film. In the case of the above conditions, Si film becomes to have a fine crystalline structure to be broadened in energy band width, thereby becoming an emitter including heterojunctions. By this, it becomes possible to produce a bipolar transistor having current amplification $h_{FE}$ than the twelfth example.

In this example, Ar gas was introduced into the chamber, but by also introducing $H_2$ gas, dangling bonds of Si could be terminated during film formation of fine crystalline silicon, whereby recombination of carriers at the base-emitter interface or within the emitter was reduced to give good characteristics.

(Fourteenth example)

Next, the fourteenth example of the present invention is described by referring to Fig. 24. Concerning the same positions, the same symbols were attached, and the base regions of the twelfth and the thirteenth examples were formed by ion injection, but the base region 540 of the fourteenth example of the present invention is a Si epitaxial layer, which can take an extremely thin structure as compared with the twelfth and the thirteenth examples. Also, by further removing the emitter forming site on the above-mentioned thin film base region 504, a metal 541 for base electrode is formed, and therefore the external base resistance becomes substantially zero. From the two points, the bipolar transistor of the fourteenth example has the advantage that further higher speed actuation can be effected as compared with those possessed by the twelfth and the thirteenth examples.

Next, the method for preparing the transistor of the fourteenth example is described by referring to Fig. 25.

Up to the steps shown by Fig. 22D which is the diagram showing the preparation steps of the twelfth example, formation was condcuted according to the same method. However, the base region of the fourteenth example, which consisted of a thin film epitaxially grown instead of the diffused layer into the epitaxial layer 504 as described above, was previously made to have an epitaxial layer 504 thickness thinner as compared with the twelfth and the thirteenth examples.

After selective oxidation, the $Si_3N_4$ film used for selective oxidation was removed by etching, and etching was effected with dil. hydrofluoric acid until the epitaxial layer 504 and the Si surface of the collector electrode take-out region 506 were exposed. The steps of performing washing the above wafer with $H_2SO_4:H_2O_2=4:1$ for 5 minutes, with water 5 minutes, with dil. hydrofluoric acid ($HF:H_2O=1:50$) to remove the naturally oxidized layer and washing with water for 5 minutes were repeated twice, and a $P^+$ :Si film was attached to 100 to 500 Å by a RF-DC combined sputtering device. The formation conditions are as follows. After introduction of 3 m torr of Ar gas into a RF-DC combined bias sputtering device of a background vacuum degree of $1 \times 10^{-10}$ torr, on the Si target side doped with B were applied a DC bias of - 25V and a high frequency power of 100 MHz at 5W, while on the wafer side was applied a DC bias to make the substrate surface potential + 7V, followed by leaving to stand for 5 minutes, to perform cleaning of the wafer surface with plasma. After the cleaning treatment, on the target side, DC bias was elevated to - 200 V and the high frequency power to 40 W, while the surface potential on the wafer side was made 5 to 10 V, thereby effecting thin film formation which became the base region. After the thin film formation, the wafer was moved to the RF-DC combined bias sputtering device for Al film formation, and film formation to 2000 to 6000 Å was carried out under the same conditions as in the twelfth example. After film formation, as shown in Fig. 25A, the base layer 541 and the Al 542 for base electrode were subjected to patterning by photoresist working.

Next, the wafer was introduced into a CVD device, and as shown in Fig. 25B, a $SiO_2$ film was formed as the interlayer insulating film 543. The insulating layer is not particularly limited to $SiO_2$, but $Si_3N_4$, etc. may be also employed.

Next, in the emitter region and the collector electrode take-out region, holes of 544 and 545 in Fig. 25C are opened on the above-mentioned interlayer insulating layer.

The wafer is passed through the same emitter forming steps as in the twelfth example to form a Si film 546 as shown in Fig. 25C. As the Si film in the emitter region, it is not limited to the single cyrstal layer of the twelfth exmaple, but a microcrystalline silicon layer as in the thirteenth example may be also employed. The process after formation of the Si film for emitter is the same as in the foregoing examples, and therefore its description is omitted.

(Fifteenth example)

The fifteenth example of the present invention is described by referring to Fig. 26. The same positions are attached with the same symbols and description thereof is omitted. The base region of the fourteenth exmaple was formed of a Si thin film, but as can be seen from Fig. 26, the base region 547 of this example is different therefrom in that it consists of of a ultra-lattice structure of $Si_xGe_{1-x}$ layer of Si layer and $Si_xGe_{1-x}$ layer. As x, for example, one with x=0.9 to 0.7, etc. may be employed, whereby the number of misfit density due to difference in lattice constant between Si and SiGe can be inhibited. Also, when a ultra-lattice structure of Si and SiGe is employed, the respective film thicknesses may be about 5 to 50 Å. In preparation of these ultra-lattices, within the RF-DC combined bias sputtering device used for Si film formation of the foregoing examples are placed two kinds of targets of Si and SiGe, and by changing over the RF-DC bias application to the targets, ultra-lattice can be formed. Also, in such ultra-lattice base region, it is desirable that the SiGe layer should be in contact with the interface with the emitter region, and the Si layer with the interface with the collector region. By making the structure as mentioned above, a barrier layer against positive holes is formed at the interface with the emitter, and the interface with the collector is a normal Si-Si interface without existence of the potential barrier. With such fact, the current amplification $h_{FE}$ of the above bipolar transistor can be improved. Thus, rather than enlarging the band width of the emitter, by making the band width smaller by use of SiGe as one of the base constituent materials, potential barrier by heterojunction in formed between the base and the emitter.

(Sixteenth example)

Next, the sixteenth example of the present invention is described by referring to Fig. 27. The same positions are described with the same sumbols. The specific feature of this example resides in that the wiring 549 functioning also as base electrode is positioned beneath the thin film base region 550. The advantage of this structure is that the parastic capacity other than the semiconductor junction capacity of the emitter-base can be reduced, because the base electrode and its wiring metal 549 are surrounded with a thick insulating layer except for contact with the thin film base region 550. Further, even if spikes are generated from the embedded metal, no leak will occure therefrom.

Next, the method for preparing the device of the sixteenth example is described briefly by referring to Fig. 28. As shown in Fig. 28A, on the field oxidized film 548 was formed an Al film by a RF-DC combined bias sputtering device, followed by patterning as shown by 549 by photoresist working. Next, the base layer was formed by a RF-DC combined bias sputtering device, and as shown by 550 in Fig. 28B, patterning was effected. After formation of the base layer 550, the insulating layer of 551 in Fig. 28C was attached by a CVD device, and holes were opened by resist working at the emitter portion and the collector portion regions. After hole opening, $n^+$ Si layer was formed by a RF-DC combined bias sputtering device, followed by patterning as shown by 552 in Fig. 28C.

(Seventeenth example)

Next, the seventeenth example is described by referring to Fig. 29. The same positions as described in the foregoing examples are written by the same symbols. The specific feature of this example is that, as can be seen from Fig. 29, the wall 557 of the insulating film 558 in the vicinity of the base collector junction is substantially vertical as compared with the structure of the sixteenth example, and even the base

collector junction face is flattened. By this fact, the junction capacity between base and collector can be reduced to accomplish higher speed. Up to examples 12 to 16, as the oxidized film for separation, one obtained by the selective oxidation method has been employed, but the structure of this example was formed by forming an epitaxial film, then forming a groove cut vertically according to the reactive ion etching (RIE: Reactive Ion Etching) technique on the region where the oxidized film was formed, placing the wafer in a CVD device, attaching an insulating material thereon and then effecting etching to the surface to form a flat surface.

(Eighteenth example)

Next, the eighteenth example of the present invention is described by referring to Fig. 30. The same positions as in the previous seventeenth example are written by the same symbols. The specific feature of this example, as can be seen from Fig. 30, resides in the structure of using a $p^-$ substrate 559 as the substrate and providing a $p^-$ layer 560 between the $n^+$ embedding layer 503. This effect is described. When great current is momentarily passed through the bipolar transistor, the potential of the collector layer will be fluctuated. Between the $n^+$ embedding layer 503 which determines the collector potential and the p substrate 559, a reverse bias for device separation is applied to form a depletion layer therebetween. As the actuation frequency becomes higher, the depletion layer can not respond momentarily to the applied voltage to be delayed in time. At this time, the constant is dictated by the capacity C determined from the whole resistence R of the p substrate and the depletion layer width. Therefore, if the substrate resistance is great, it has great influence on the switching speed of the bipolar transistor. Accordingly, by use of a highly concentrated substrate and by forming a $p^-$ layer between this and a $n^+$ embedding layer, the time constant of the above RC was made small. As described above, in the present eighteenth example, lowering in switching speed by the depletion layer response on the substrate side can be prevented.

(Nineteenth example)

Next, the nineteenth example of the present invention is described by referring to Fig. 31. In Fig. 31, 561 is a $p^+$ layer on the p-type single crystalline Si substrate back surface, 562 a $p^-$ layer, 563 a $p^+$ layer for device separation, 566 a $n^+$ embedding layer, 570 a metal embedding layer surrounded by the above $n^+$ embedding layer, 571 a $n^-$ type epitaxial layer, with the vicinity of the interface between the embedding metal layer and the n layer 571 being a $n^+$ layer. 572 is an insulating layer around the above epitaxial, 573 an embedding base electrode, 574 an extremely thin $p^-$ base thin film, of which thickness is about 100 Å similarly as in the twelfth exmaple. 575 is a $n^+$ Si film for emitter, 576, 577 are respectively metal electrode and metal wiring for emitter and collector, 578 is an interlayer insulting layer, and 579 a passivation film.

As can be seen from Fig. 31, in the present nineteenth example, as the embedding layer for setting collector potential, a metal is used. By this, the collector resistance becomes extremely low, and high driving ability and high speed actuation can be accomplished without anxiety about fluctuation of collector potential even during great current acutuation.

Next, the preparation method of the present nineteenth example is described referring to Fig. 32. As shown in Fig. 32A, $p^-$ layer 561 was formed at the whole back surface of the p substrate 562 and $p^-$ layer 563 was formed in the device separation region.

Next, in the device separation region, a $SiO_2$ layer 564 was provided on the above wafer furface as shown in Fig. 32B, and anisotropic etching was effected with the use of this as the mask. As the etchant, KOH:isopropyl alcohol = 4:1, etc. may be employed. At that time, after formation of a thermally oxidized film on the wafer surface, implantation may be also effected. After implantation, annealing was carried out in a $N_2$ atmosphere of 900 °C to activate the implanted As.

Next, the $SiO_2$ layer on the wafer surface was removed by etching, and, so that Si surface without naturally oxidized film could be exposed, the operations of washing with $H_2SO_4$:$H_2O_2$ = 4:1 for 5 minutes, with water for 5 minutes, with HF:$H_2O$ = 1:50 for 20 seconds and with water for 5 minutes were repeated twice.

The washed wafer was placed in a RF-DC combined type bias sputtering device for Al film formation, and film formation of Al shown by 567 in Fig. 32C was performed to the region embedding the groove formed by the anisotropic etching. However, cleaning of the wafer surface with Ar ions before film formation is the same as in the twelfth example.

As can be seen from Fig. 32C, when Al film formation is performed by the device, the shape becomes

naturally to flatten the step difference. This may be considered to be due to the fact that the edge region of the groove is more susceptible to sputtering. Subsequently, the wafer was placed in a RF-DC combined type bias sputtering device to provide an epitaxial layer 568. The above Al film is crystallized, and therefore Si also becomes an epitaxial film. The film forming conditions are the same as in the twelfth example and therefore description thereof is omitted. The concentration of the epi-layer is $10^{16}$ to $10^{17}$ l/cm$^3$, and for obtaining good contact with the metal layer, a polycrystalline Si target doped with 1 x $10^{21}$ l/cm$^3$ was used at initiation of film formation, and then the target was changed over to give a desired epitaxial concentration. When the epi-layer is formed according to this method, the epitaxial film thickness and the epitaxial concentration can be controlled well. Thus, after film formation of the embedding metal 567 and the epitaxial layer 568, the surface was subjected to uniform etching to an epi thickness of 1000 Å, and yet so as to have the embedding metal, the $p^+$ layer for device separation exposed on the surface. This wafer was further subjected to etching to provide a groove shown by 569 around the region where the emitter of the bipolar transistor was to be formed, as shown in Fig. 32D. The depth of the groove was set shallower than the embedding metal 570, and deeper than the epitaxial layer 571. On the wafer surface having formed the groove 569 thereon was formed an insulating layer, and again etching was effected until the epitaxial layer surface was exposed to make the surface flat. In forming the insulating surface flattned, it is possible to use the bias ECR method, the liquid phase CVD method, etc.

Next, the wafer was placed in a RF-DC combined bias sputtering device for Al film formation, and the film of the electrode 573 of an embedding metal for base was performed. After film formation, on the insulating layer 572 embedded in the groove 569 was effected patterning as shown in Fig. 32E. After formation of the base electrode, the base layer shown by 574 in Fig. 32F was formed by a RF-DC combined bias sputtering device for Si film formation. After formation of the base, the interlayer insulating layer was formed, a hole was opened at the emitter portion and Si for emitter was deposited. The Si for emitter was subjected to patterning to form an emitter 575, further an interlayer insulating layer 578 was attached, followed by opening of holes for emitter, collector electrodes, to form metal wirings 576, 577.

As described above, by formation of a metal by RC-DC combined sputter, the metal is single crystalline, and a single crystalline Si could be grown on the single crystalline metal at low temperature to accomplish the structure of this example.

In this example, the film of a metal was formed on Si substrate, and a device formed thereon, but the present device can be also formed on a metal substrate as a matter of course.

(Twentieth to twenty-third examples)

Next, by use of the bipolar transistors according the respective examples, the method of connecting the base electrode of the semiconductor device assembled in a circuit to another electrode and/or wiring is described. The device according to the present invention is basically constituted of a base electrode which is a metal, and therefore can easily take the system of being used at the same time as wiring and bonded to another electrode in the region in the system where there is a space. Its examples are described as the twentieth to twenty-third examples by referring to Figs. 33 to 35. In Figs. 33 to 35, 601 is a substrate, 680 an insulating layer represented by the field layer, 682 and 688 metals for base electrodes, 681, 684, 686, 690 are interlayer insulating layers which are BPSG (boron phospho silicate glass), PSG (phospho silicate glass), NSG (nondoped silicate glass), etc. prepared by CVD device. 683, 687, 691 are metals for emitter or collector electrodes and wiring, and 685 is a $n^+$ Si layer. As shown in Fig. 33, the metal electrode 682 for the base may be connected to the emitter or the collector wiring metal 683 through the thru-hole 692 on the insulating layer 680, or conneted to the emitter or collector wiring metal 687 through the $n^+$ Si layer 685 similarly as the emitter, collector electrode. By use of the constitution as shown in Fig. 34, no mask for thru-hole is required to effect simplification of the steps. Also, as shown in Fig. 35, when there is a base electrode and a metal for wiring on the side below the base layer, contact may be taken with the metal 691 of the upper portion through the base layer 689.

(Twenty-fourth example)

Next, the twenty-fourth example is described by referring to Fig. 36. The basic constitution is the same as the fourteenth example. In the twenty-fourth example, between the $n^+$ layer 739 and the base layer 707, a n-layer 7120 with lower concentration than the above $n^+$ layer 739 is provided. This structure can be obtained by using merely a target with lower concentration than the above $n^+$ layer 739 during formation of

Si for formation of emitter on the base layer 707, and there is no great problem in production. By use of this structure, junction mutually between high concentrations on the emitter and the base layer can be obtained, whereby not only the tunnel current can be inhibited, but also the above-mentioned junction capacity can be reduced, and further higher speed can be effected. This example has been described on the basis of the structure of the fourteenth example, but this structure is not particularly limitative, but it is also effective to provide such n-type low concentration layer also in other examples as described above.

(Twenty-fifth example)

Next, the twenty-fifth example of the present invention is described be referring to Fig. 37.

This example is basically the same as the sixteenth example, and only the different points are described. The difference of the twenty-fifth example from the sixteenth example is the point of the structure that the base layer 7122 covers completely over the base electrode portion 749. By making this structure, there becomes no restriction in process by Al exposure during the resist peeling step, the washing step after patterning in the base layer, whereby degree of freedom can be expanded.

Of the examples as described above, for example, the bipolar transistores of the twelfth to twenty-fifth examples have the effect that, by using a metal as the base electrode material, reducing the base resistance, and also making the above-mentioned base electrode an embedded structure, thereby using it also as the wiring, whereby no contact between the base electrode material and the wiring is required to be provided around the emitter to enable higher speed, higher integration with reduced area necessary for one element.

## Claims

1. A semiconductor device comprising a transistor, having a bipolar transistor structure, an emitter•base junction interface being flat, with the emitter portion being constituted of a thin film having therein a region with varied energy band width.

2. A semiconductor device according to Claim 1, wherein the emitter portion in the emitter•base junction region comprises the same single crystal semiconductor as in the base portion, and its film thickness is smaller than the diffusion length of a minority carrier.

3. A semiconductor device according to Claim 1, wherein the change in energy band width is formed by the change in amount of the inert elements contained.

4. A semiconductor device according to Claim 1, wherein the change in energy band width is formed by the change in semiconductor crystal structure.

5. A semiconductor device according to Claim 1, wherein the change in energy band width is formed by the difference in semiconductor materials.

6. A semiconductor device according to Claim 1, which has the photoelectric converting function to accumulate the charges accumulated by light at the base portion.

7. A semiconductor device according to Claim 1, wherein the base•collector junction face is flat.

8. A semiconductor device according to Claim 1, wherein electroconductivity is different from said collector portion.

9. A semiconductor device according to Claim 1, wherein $Np^- < Np^+$, when the concentration in the back surface region is made $Np^-$ and the concentration in the region near the collector is made $Np^+$ in the substrate of said semiconductor device.

10. A semiconductor device according to Claim 1, wherein an electroconductor is provided at the lower part of said collector layer.

11. A semiconductor device according to Claim 1, wherein a layer which is the same electroconductive type as the collector layer and of high purity concentration is provided in the vicinity of said electroconductor.

12. A semiconductor device having a longitudinal transistor structure with a first semiconductor region of the first electroconductive type and a second semiconductor region of the first electroconductive type and a third semiconductor region of the second electroconductive type,
characterized by having such a structure that the wiring connected electrically to said third semiconductor region is formed of a metal, provided in contact with said third semiconductor region, and said wiring is embedded within said semiconductor device.

13. A semiconductor device according to Claim 12, wherein said third semiconductor region comprises

a thin film.

14. A semiconductor device according to Claim 12, wherein said wiring is provided on an insulating layer and in contact with said third semiconductor region at a part therebeneath.

15. A semiconductor device according to Claim 12, wherein the face including the junction portion of said second semiconductor region and said third semiconductor region is flat.

16. A semiconductor device according to Claim 12, wherein the face including the junction portion of said first semiconductor region and said third semiconductor region is flat.

17. A semiconductor device according to Claim 12, wherein the electroconductive type of said semiconductor device is the second electroconductive type.

18. A semiconductor device according to Claim 12, wherein the impurity concentration in said first semiconductor region side of said substrate is lower than the impurity concentration in the region on the opposite side to said region.

19. A semiconductor device according to Claim 12, wherein an electroconductor is provided beneath said first semiconductor region.

20. A semiconductor device according to Claim 12, wherein a region of said first electroconductive type and high impurity concentration is provided in the vicinity of said electroconductor.

21. A semiconductor device having an improved transistor of a bipolar type transistor having:
a collector region comprising the first electroconductive type semiconductor,
an emitter region comprising the first electroconductive type semiconductor,
a base region comprising the second electroconductive type semiconductor different from said first electroconductive type,
characterized by having such a structure that said emitter region contains internally a region varied in energy band width,
the emitter:base junction is constituted of a substantially flat plane,
the base electrode in contact with said base region is formed of a metal material and embedded within the insulating layer region.

FIG. 1A

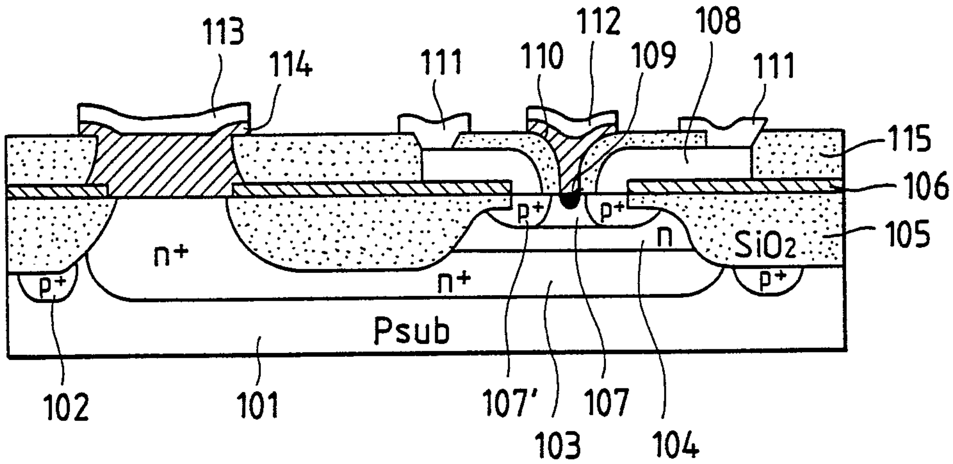
113
114
111
110
112
109
108
111
115
106
105
SiO2
n+
n+
n
p+
p+
p+
p+
Psub
102
101
107'
107
103
104

FIG. 1B

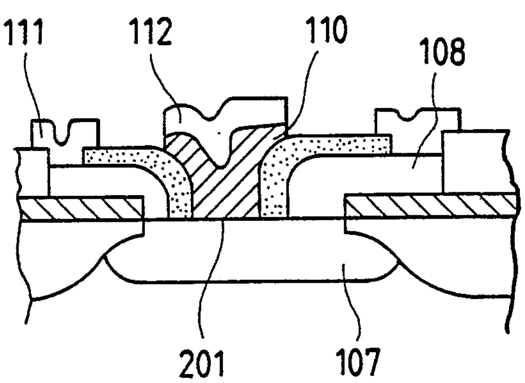
111
112
110
108
201
107

FIG. 2

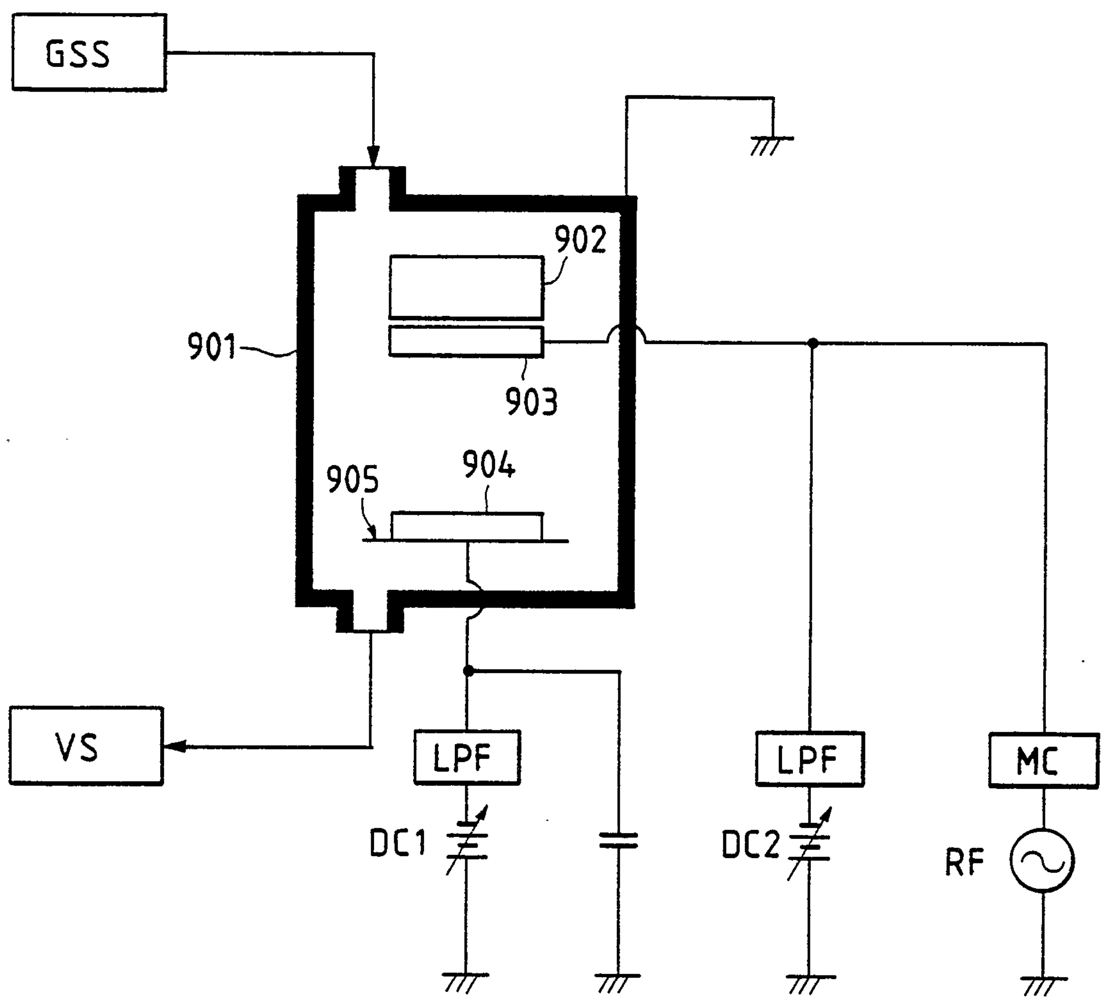

FIG. 3

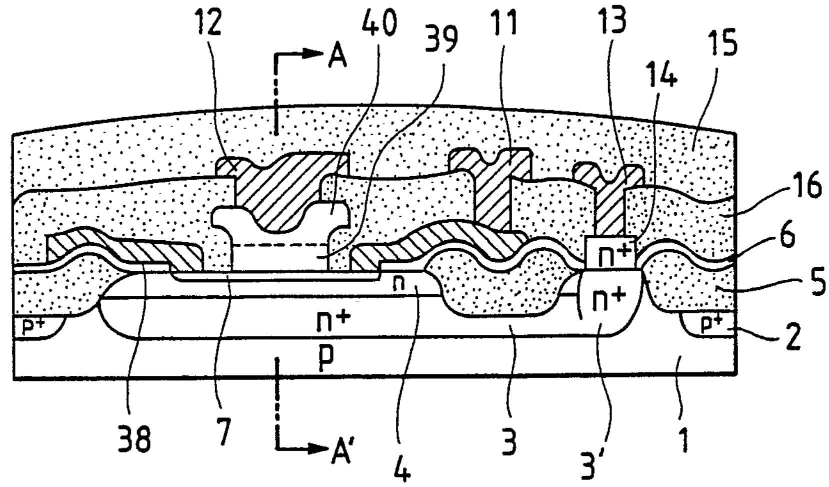


FIG. 4A

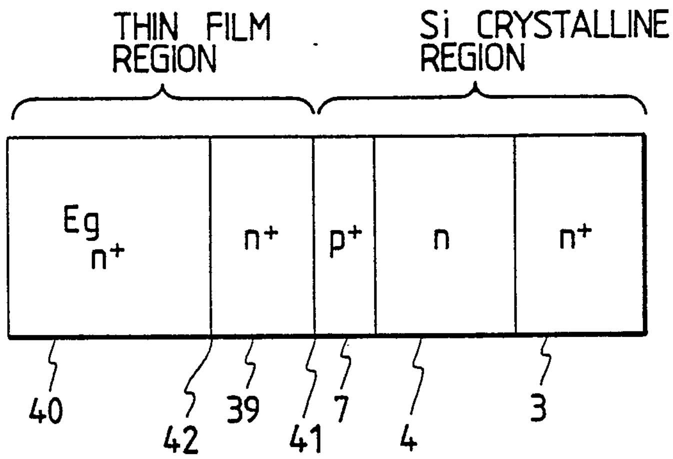


FIG. 4B

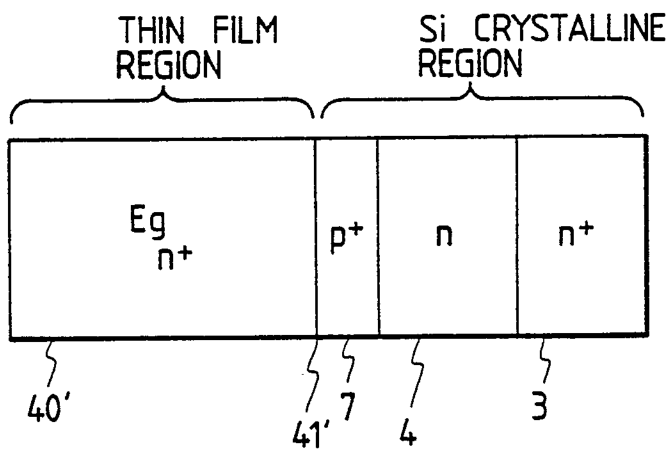


FIG. 4C

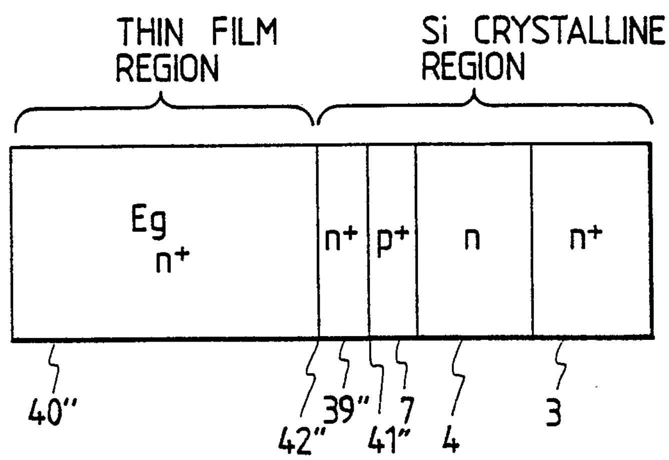

FIG. 5A

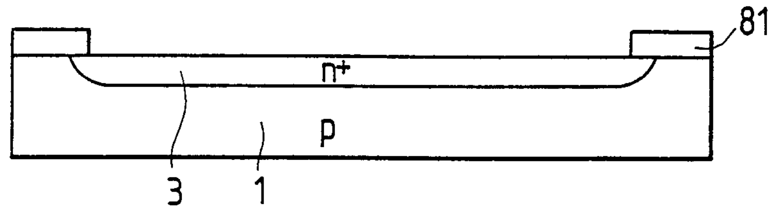


FIG. 5B

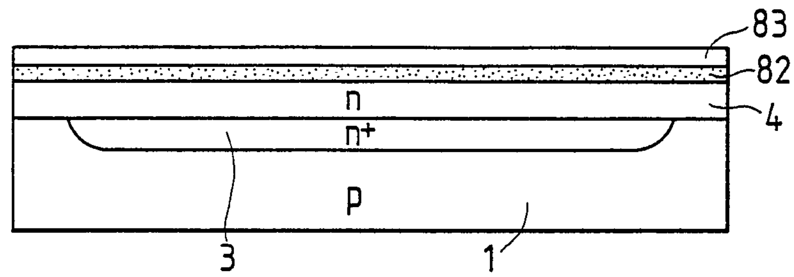


FIG. 5C

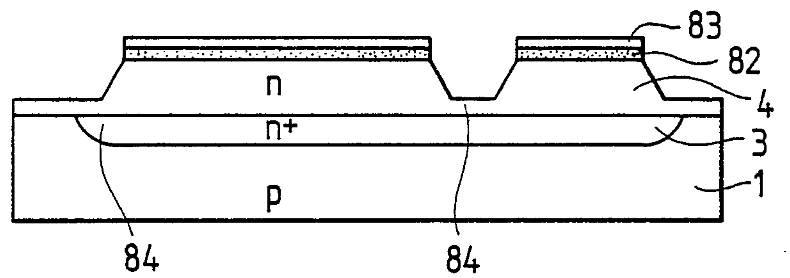


FIG. 5D

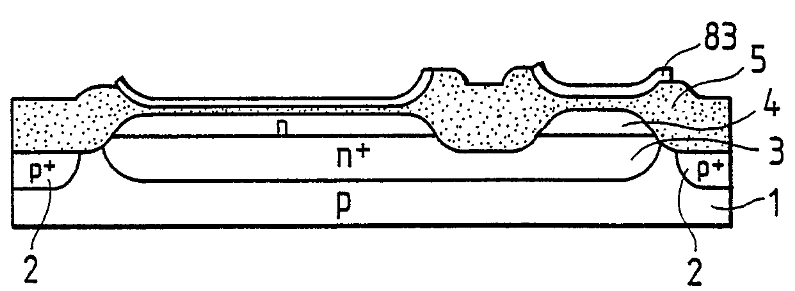

FIG. 5E

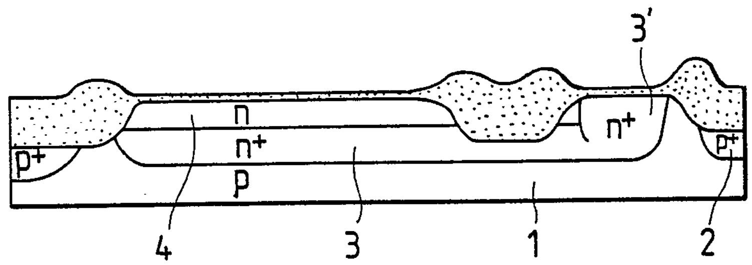


FIG. 5F

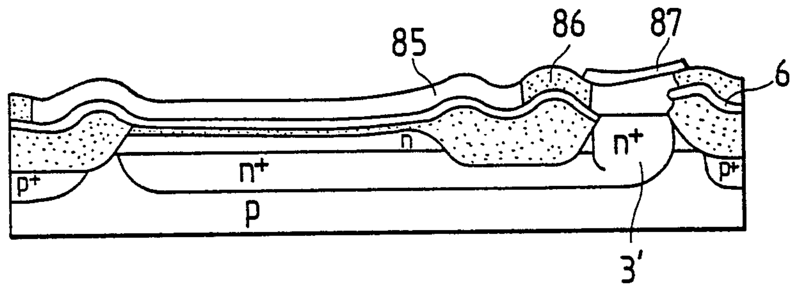


FIG. 5G

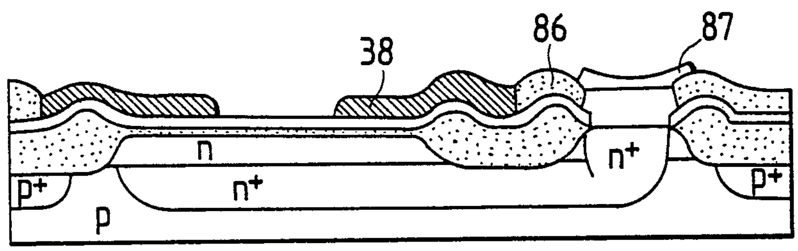


FIG. 5H

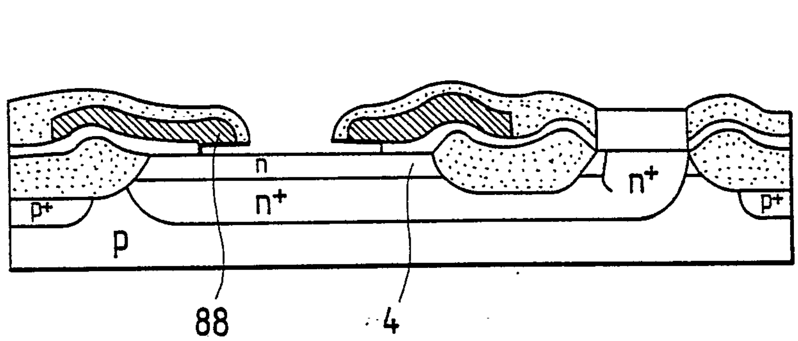

FIG. 5I

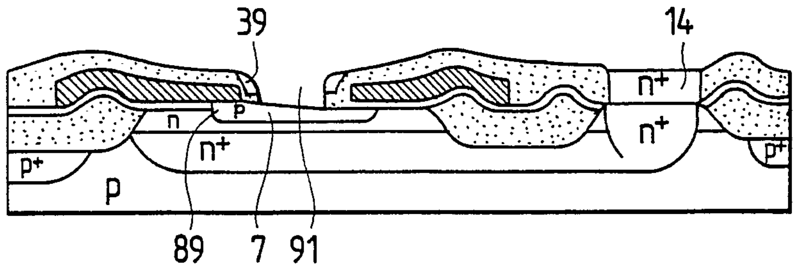


FIG. 5J

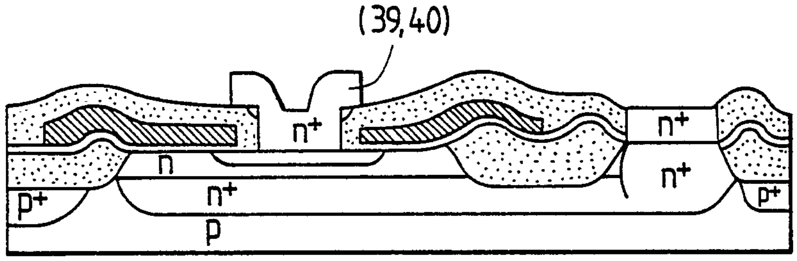


FIG. 5K

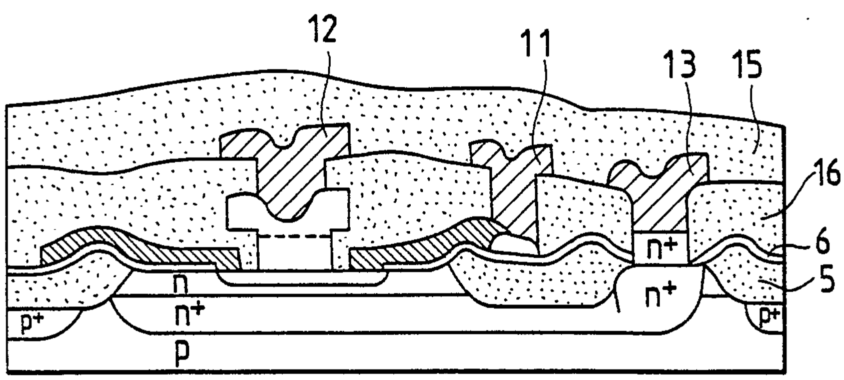

FIG. 6

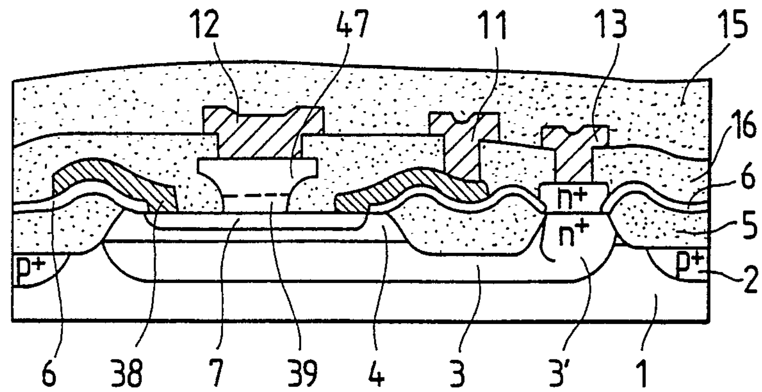


FIG. 7

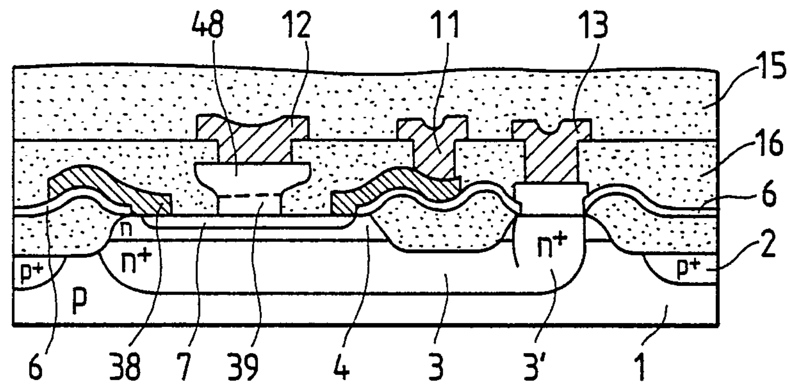


FIG. 8

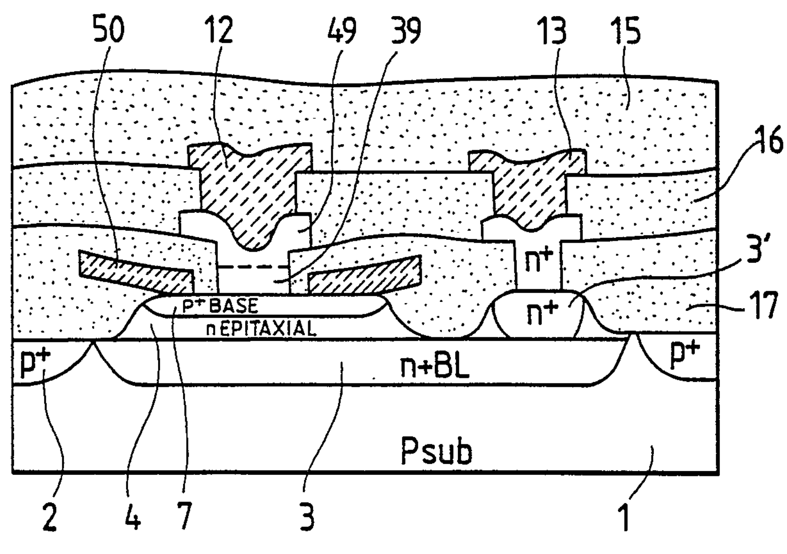

FIG. 9A

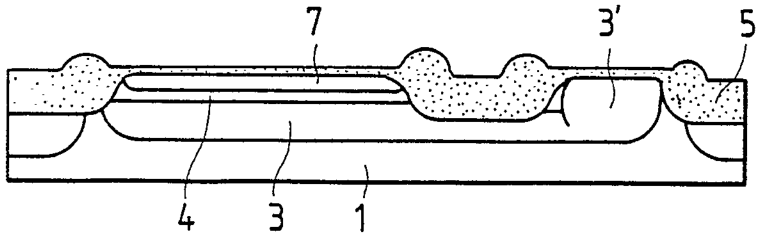


FIG. 9B

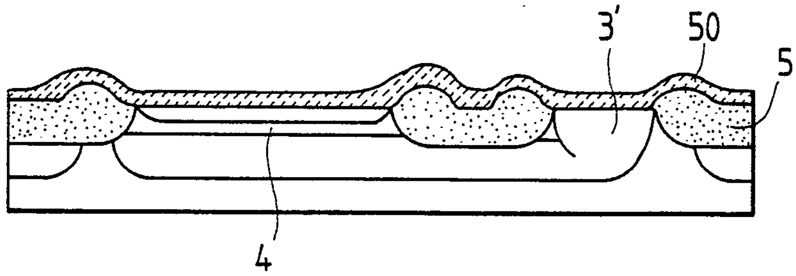


FIG. 9C

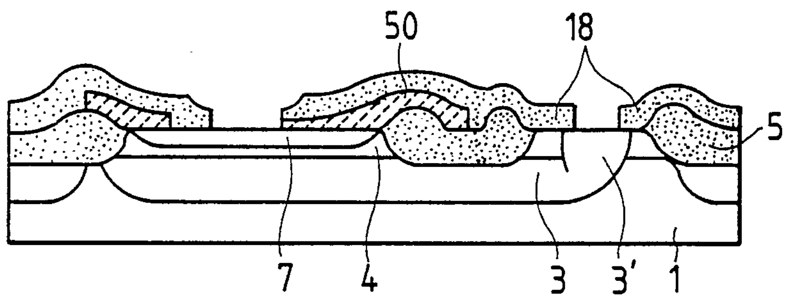


FIG. 9D

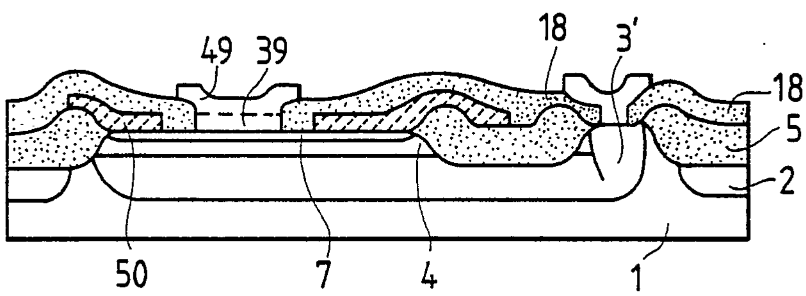


FIG. 9E

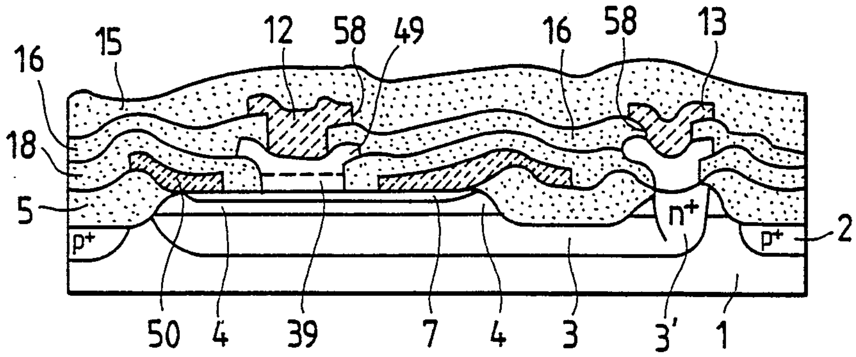

FIG. 10

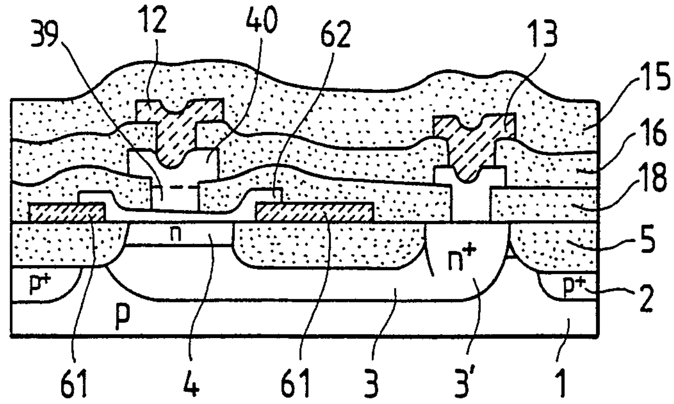


FIG. 11A

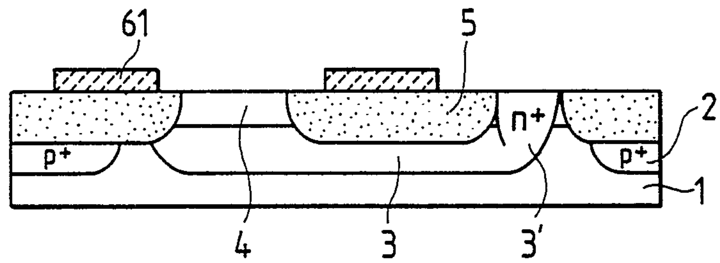


FIG. 11B

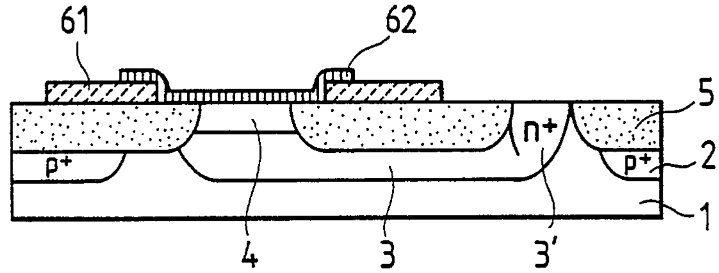


FIG. 11C

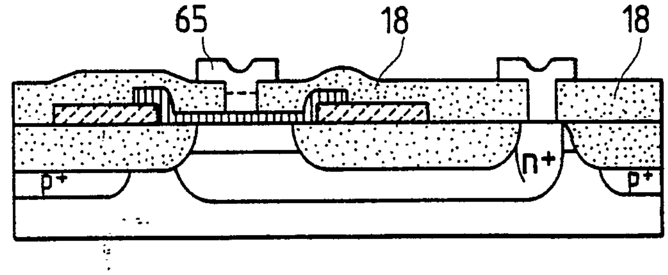

FIG. 12

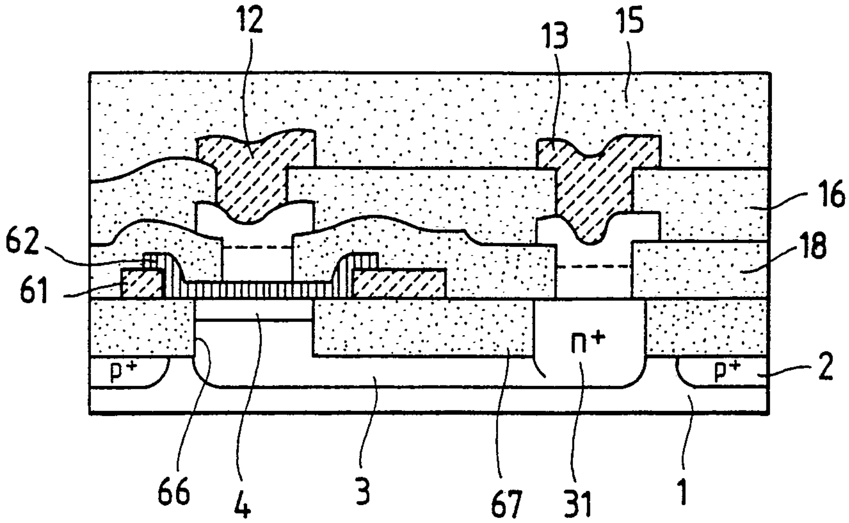


FIG. 13

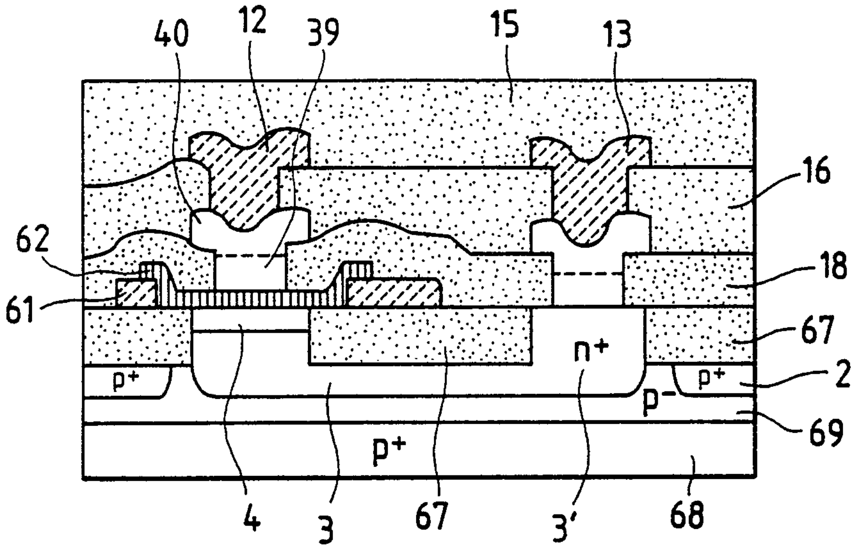


FIG. 14

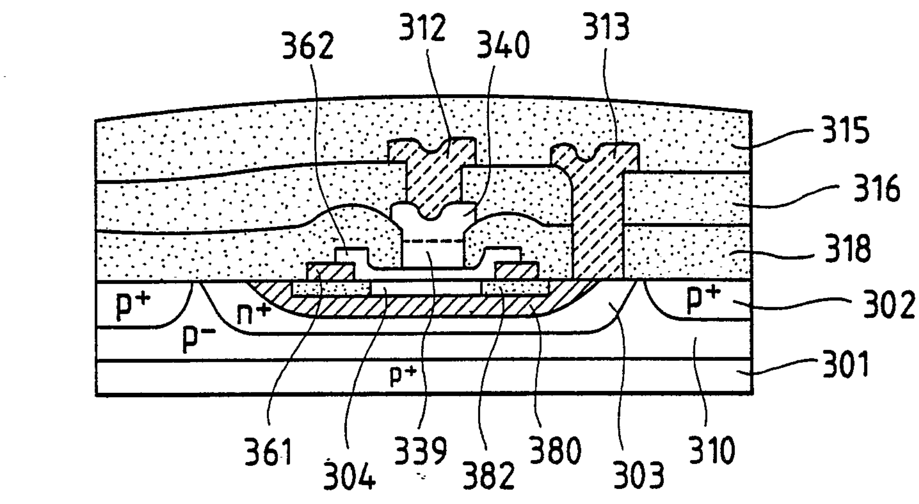

FIG. 15A

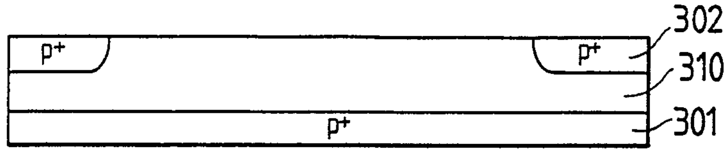


FIG. 15B

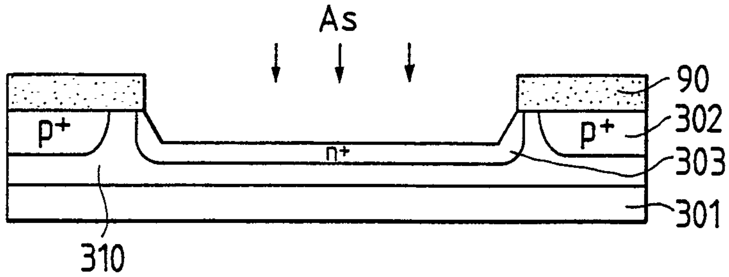


FIG. 15C

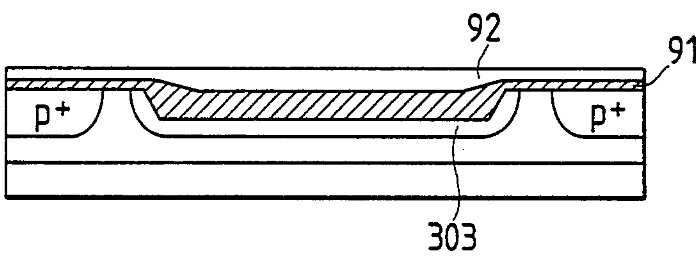


FIG. 15D

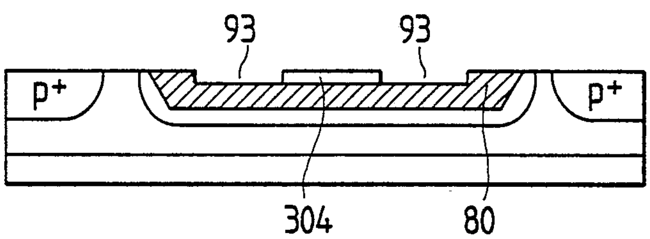


FIG. 15E

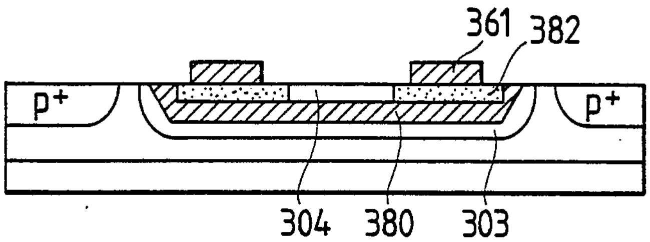

FIG. 15F

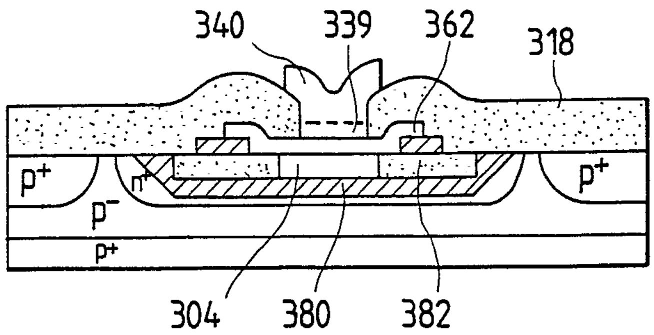


FIG. 15G

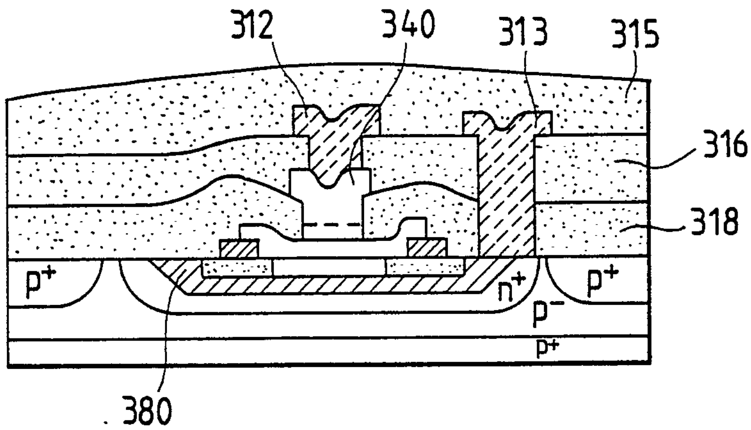


FIG. 16

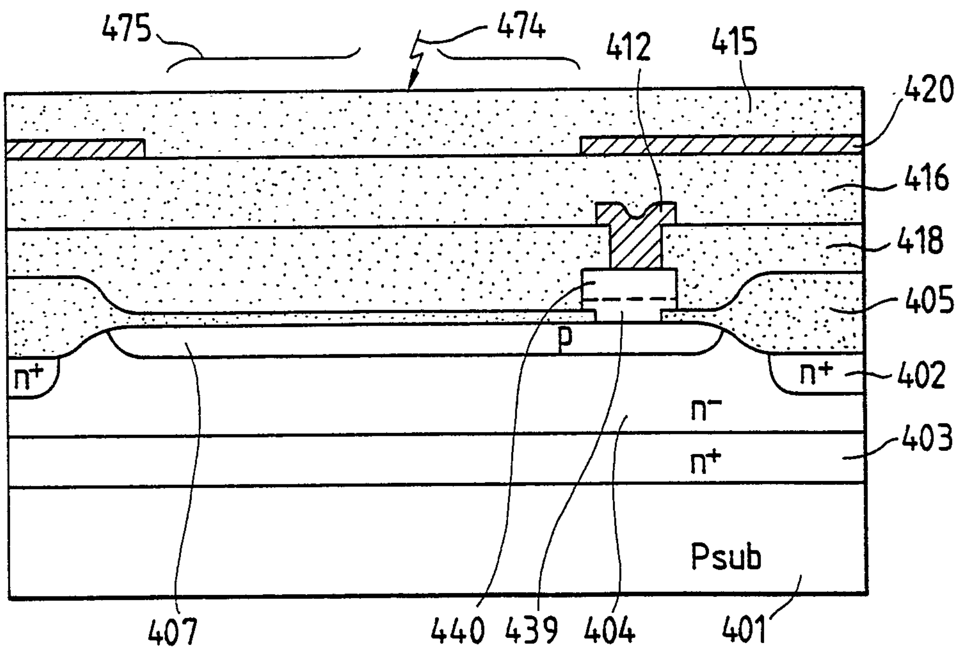

FIG. 17

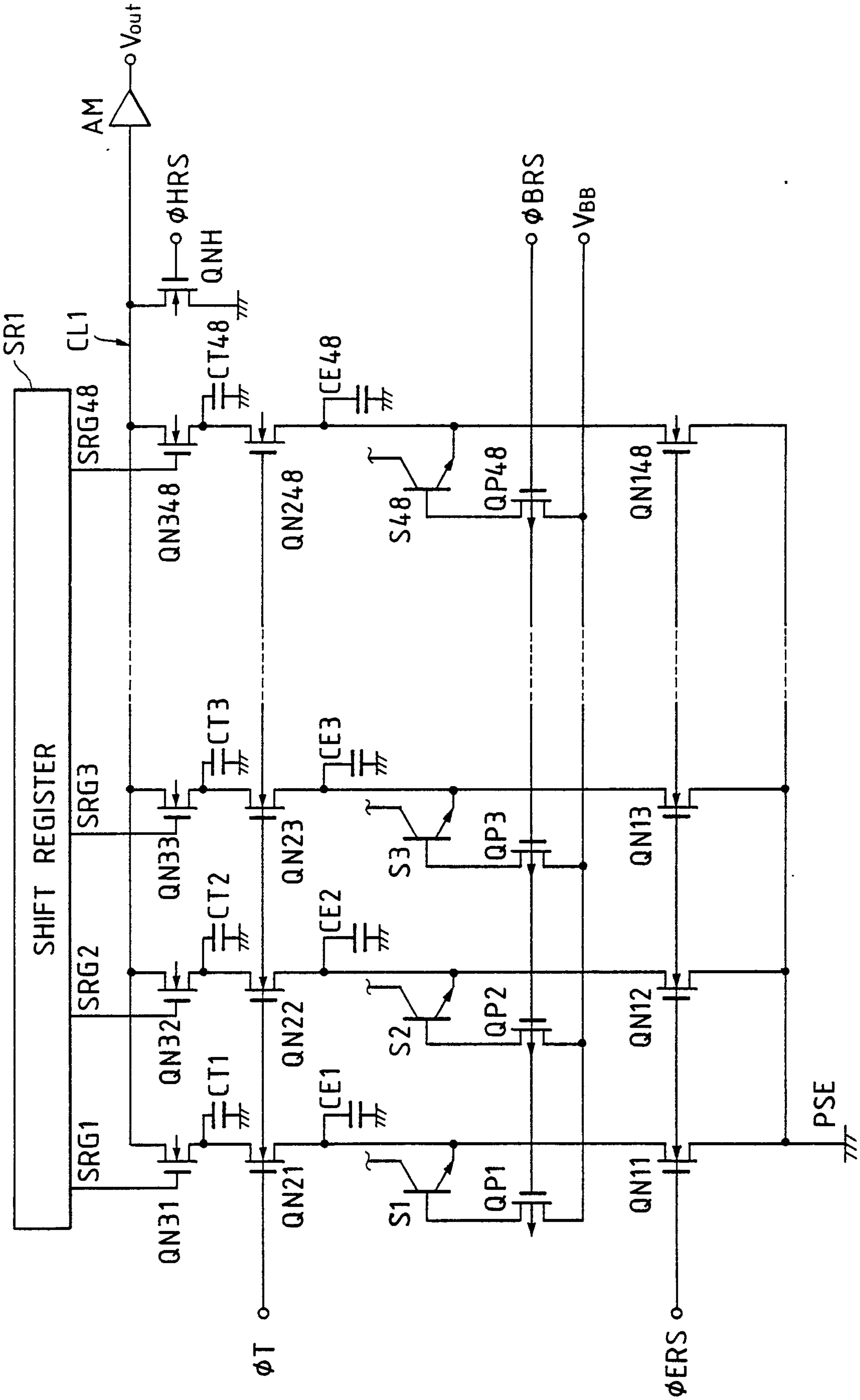
SR1
SHIFT REGISTER
SRG1
SRG2
SRG3
SRG48
CL1
AM
Vout
QNH
ϕHRS
ϕBRS
VBB
QN31
QN32
QN33
QN348
CT1
CT2
CT3
CT48
QN21
QN22
QN23
QN248
CE1
CE2
CE3
CE48
S1
S2
S3
S48
QP1
QP2
QP3
QP48
QN11
QN12
QN13
QN148
PSE
ϕT
ϕERS

FIG. 18

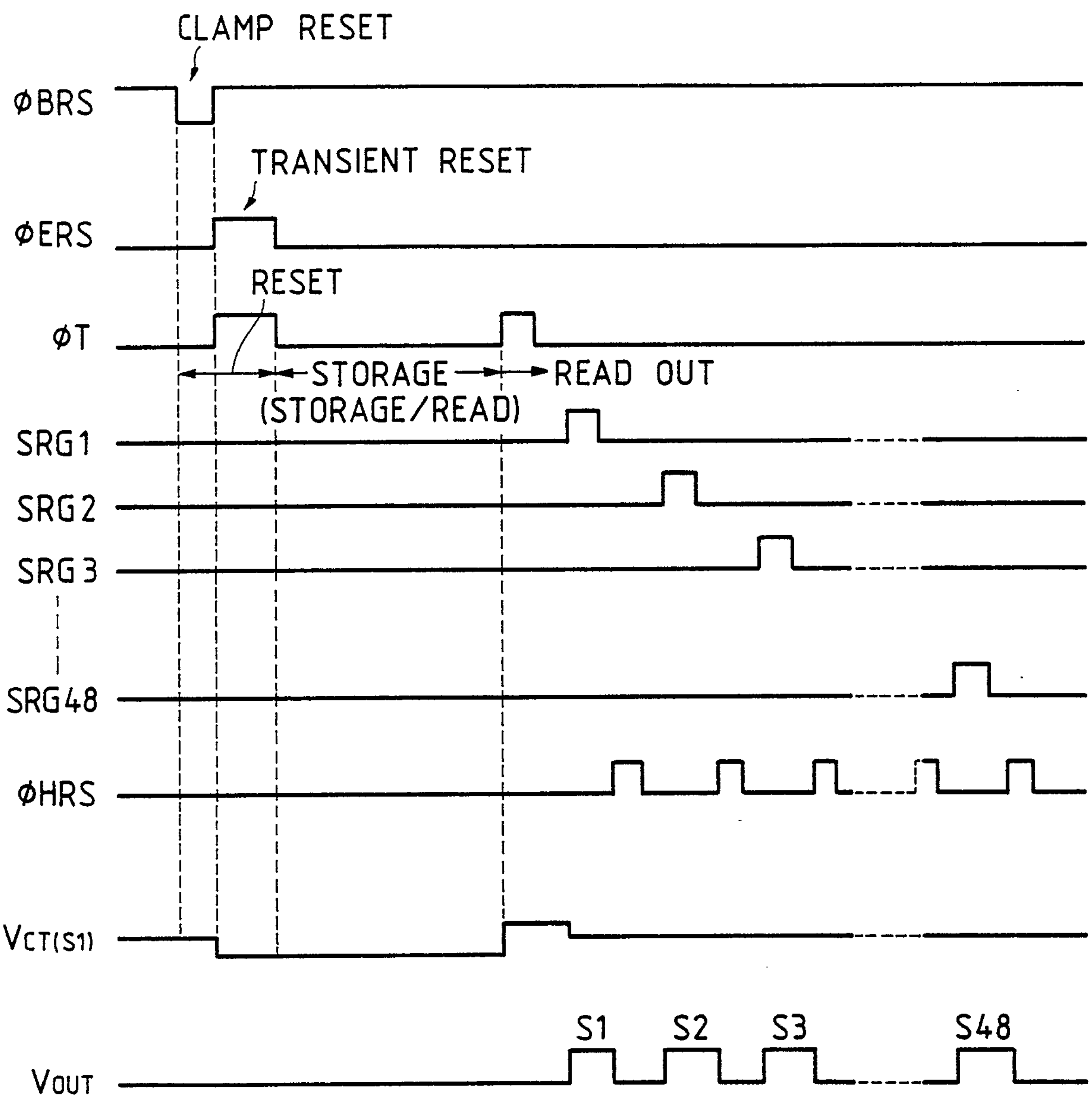
CLAMP RESET
ϕBRS
TRANSIENT RESET
ϕERS
RESET
ϕT
STORAGE
READ OUT
(STORAGE/READ)
SRG1
SRG2
SRG3
SRG48
ϕHRS
VCT(S1)
S1
S2
S3
S48
VOUT

FIG. 19

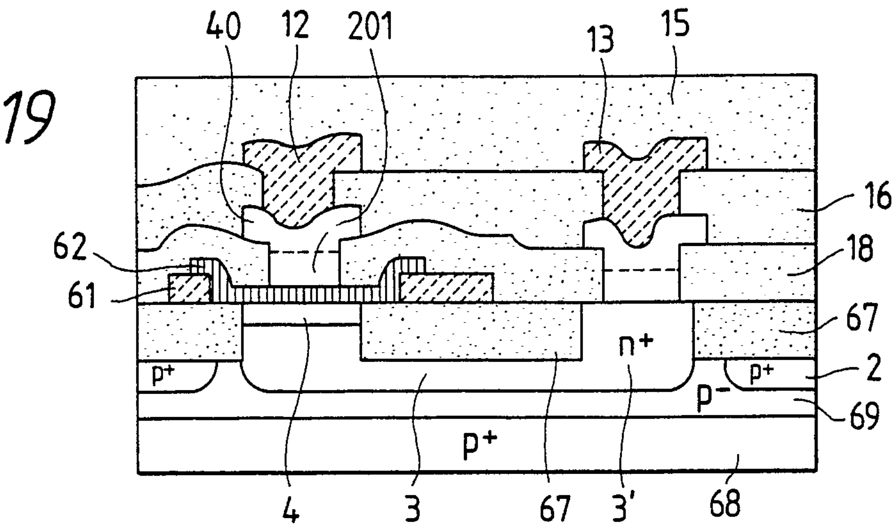


FIG. 20

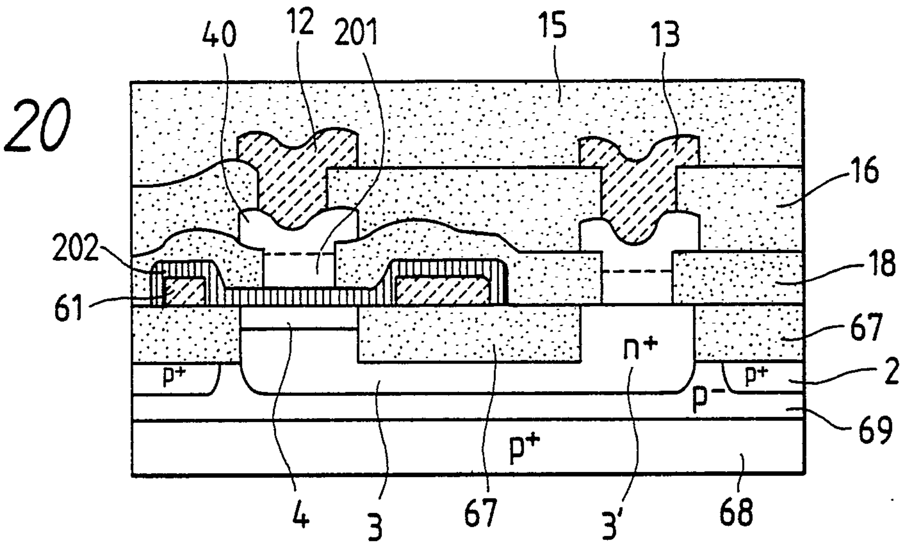


FIG. 21

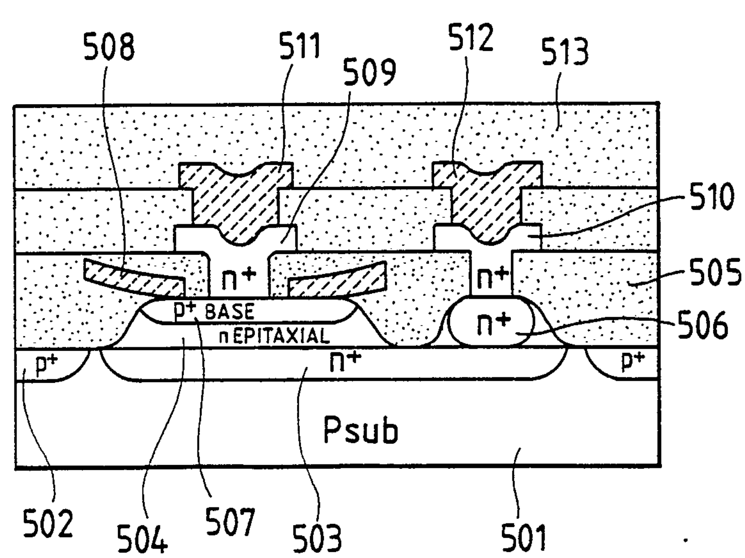

FIG. 22A

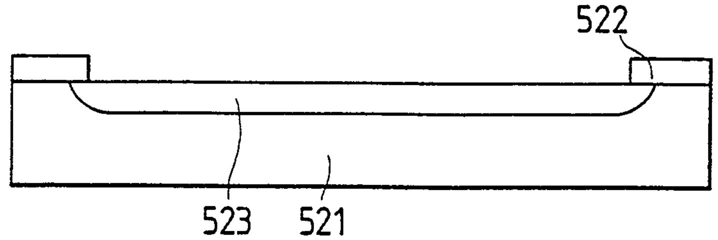


FIG. 22B

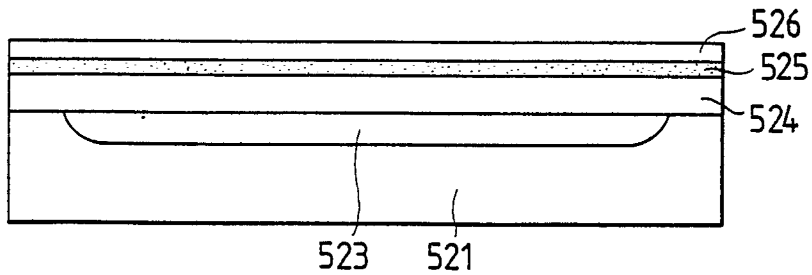


FIG. 22C

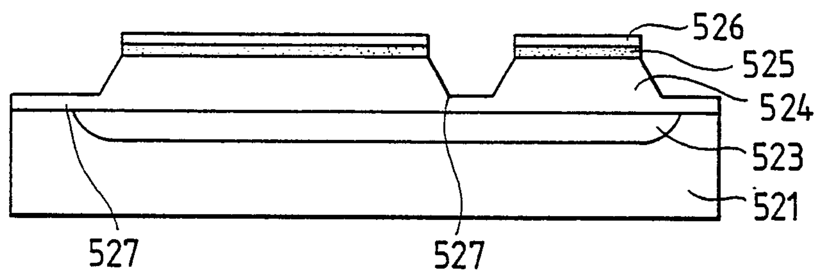


FIG. 22D

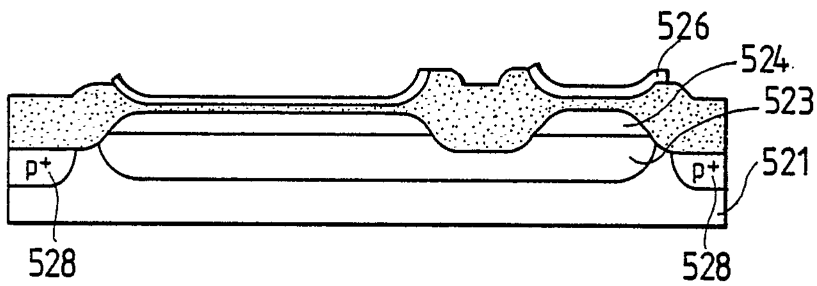


FIG. 22E

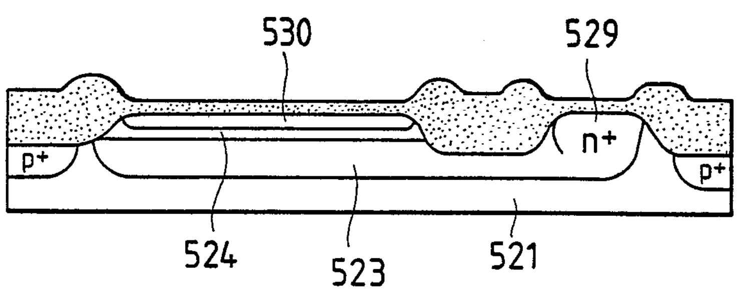

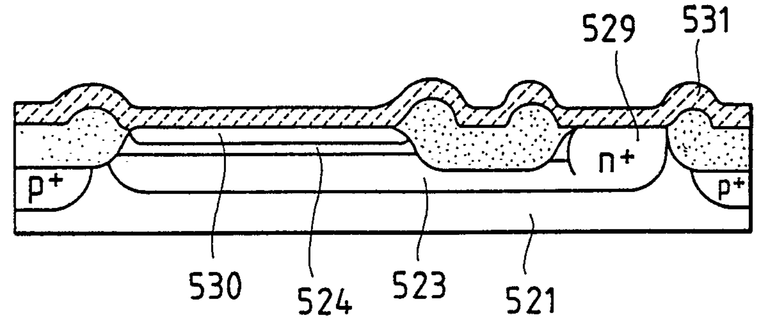


FIG. 22F

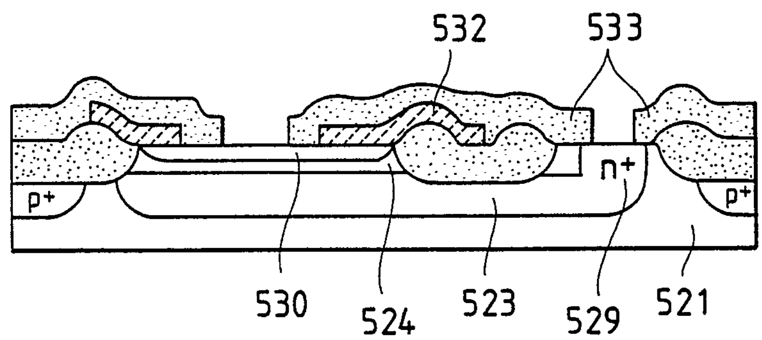


FIG. 22G

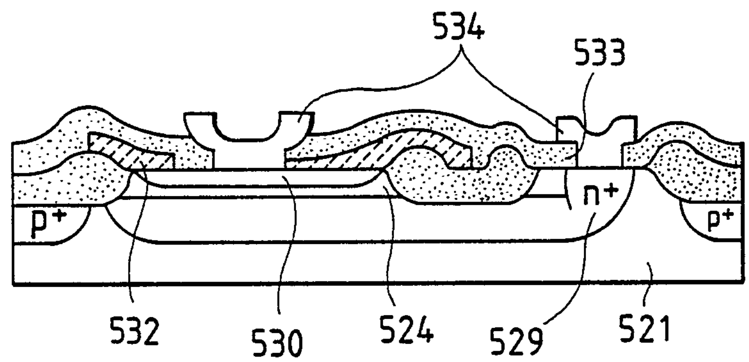


FIG. 22H

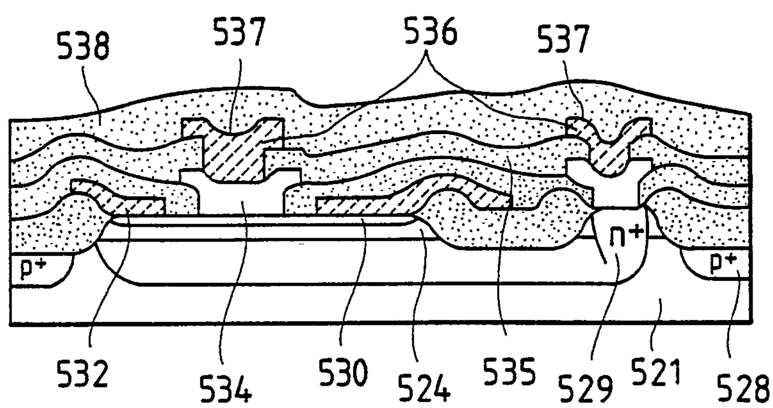


FIG. 22I

FIG. 23

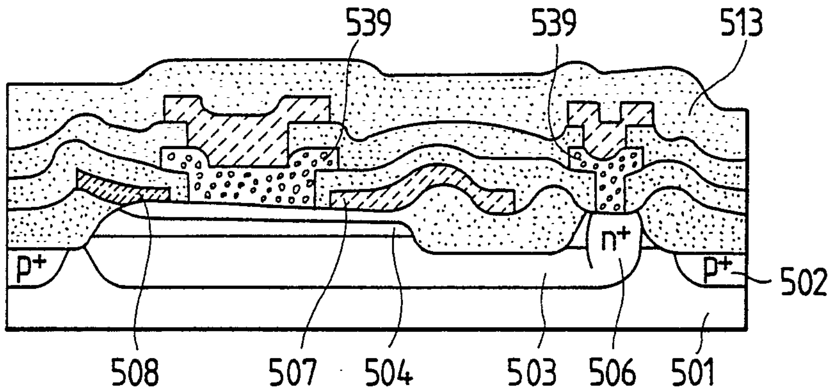
539
539
513
p+
n+
p+
502
508
507
504
503
506
501

FIG. 24

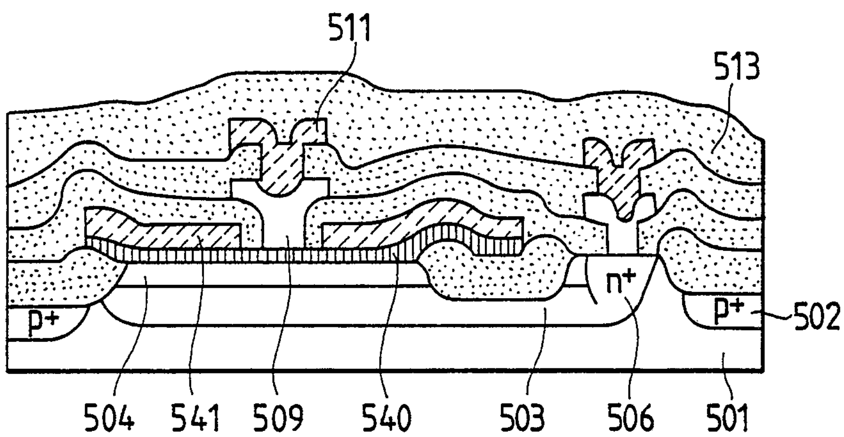
511
513
p+
n+
p+
502
504
541
509
540
503
506
501

FIG. 25A

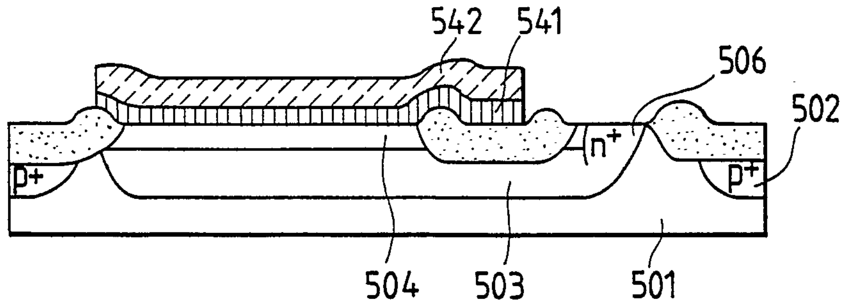


FIG. 25B

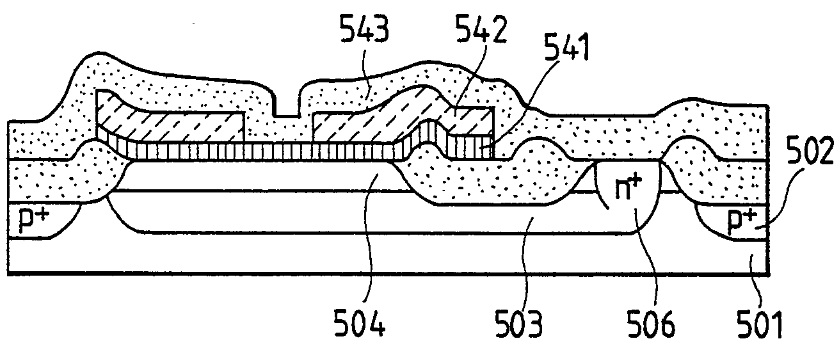


FIG. 25C

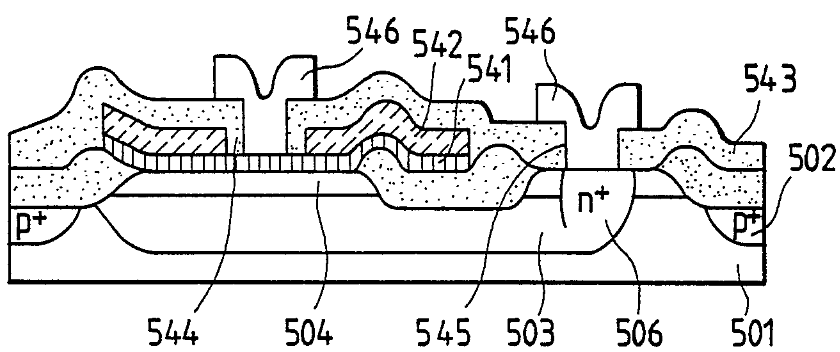

FIG. 26

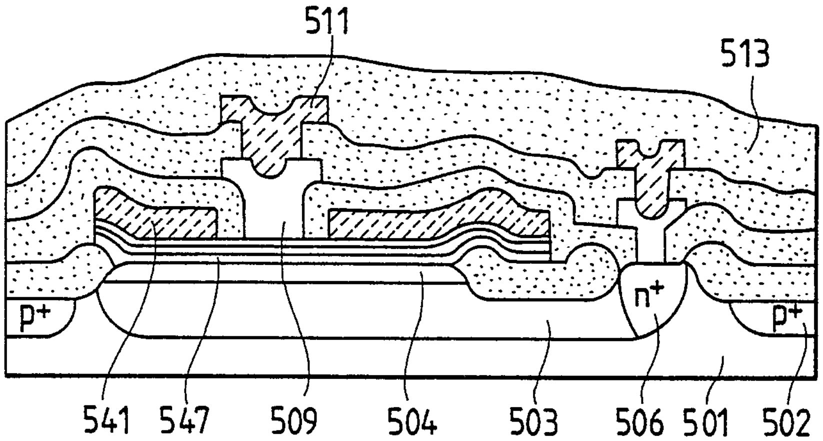
511
513
p+
n+
p+
541
547
509
504
503
506
501
502

FIG. 27

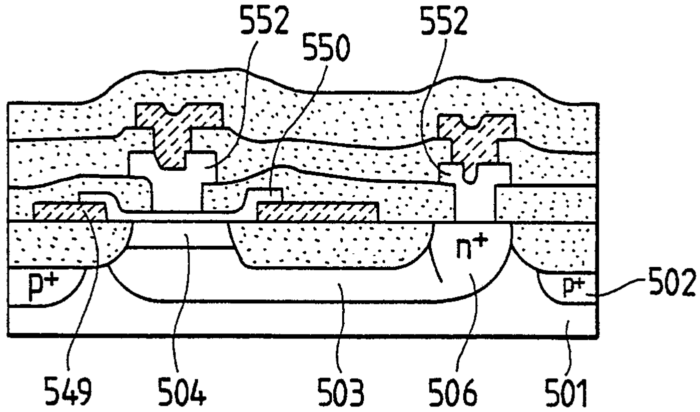
552
550
552
n+
p+
p+
502
549
504
503
506
501

FIG. 28A

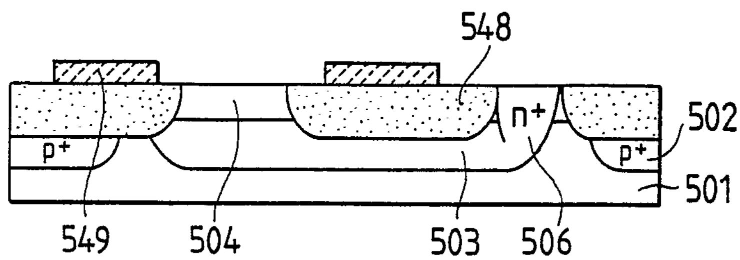


FIG. 28B

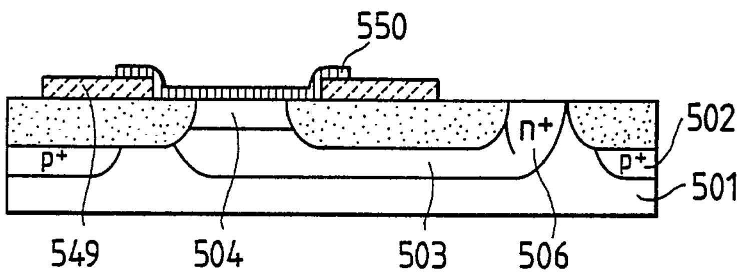


FIG. 28C

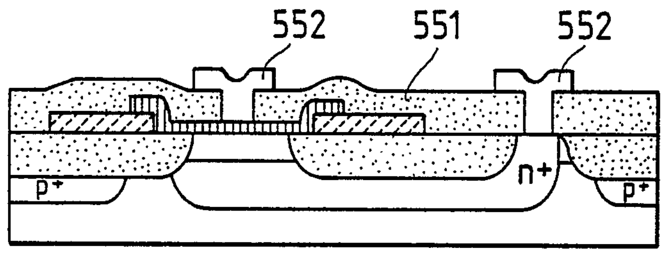


FIG. 29

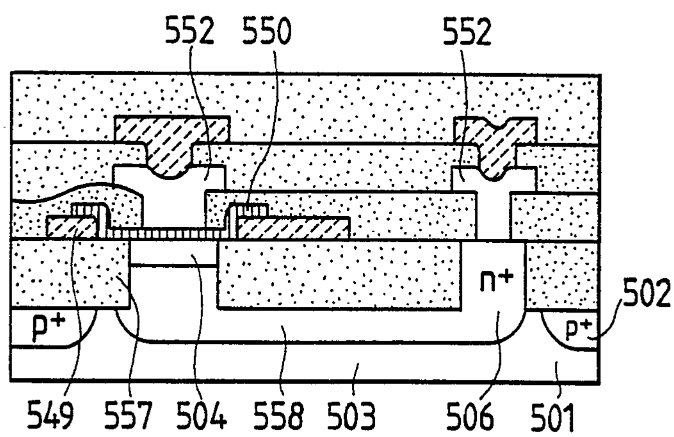

FIG. 30

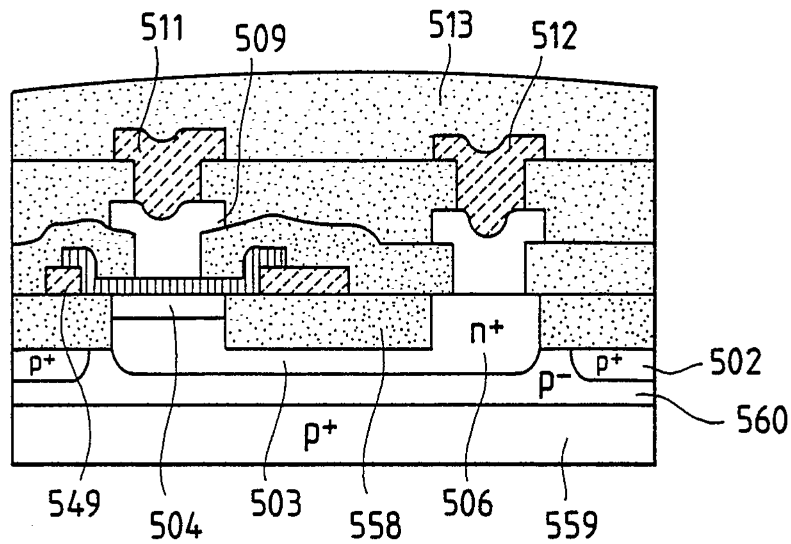
511
509
513
512
n+
p+
p+
502
p-
560
p+
549
504
503
558
506
559

FIG. 31

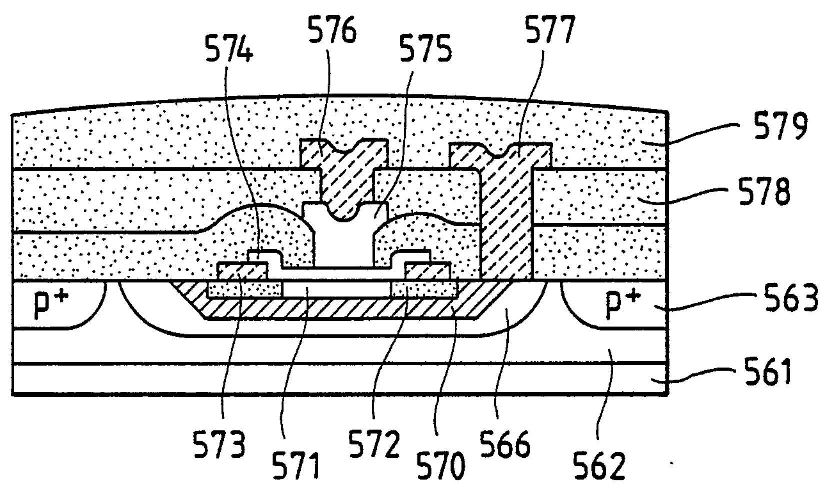
574
576
575
577
579
578
p+
p+
563
561
573
571
572
570
566
562

FIG. 32A

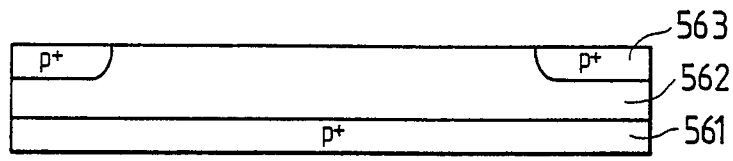


FIG. 32B

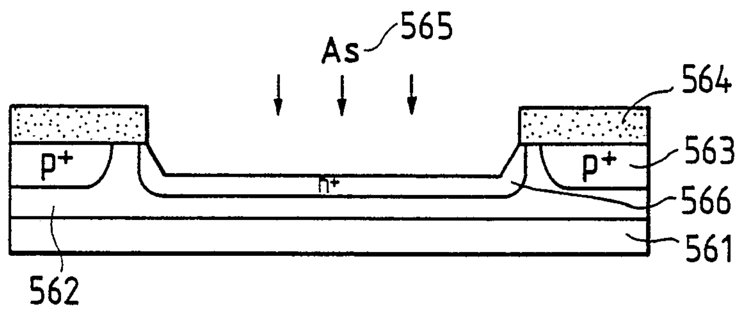


FIG. 32C

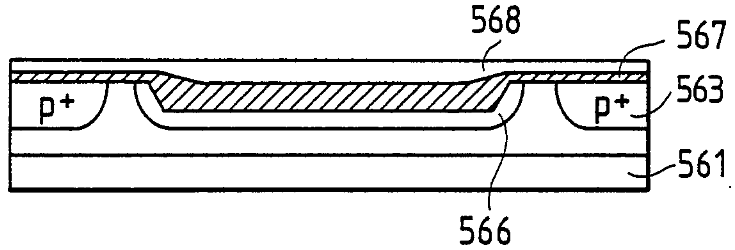


FIG. 32D

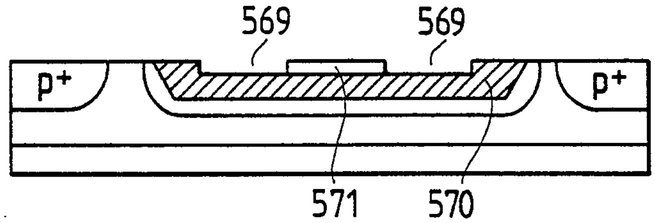

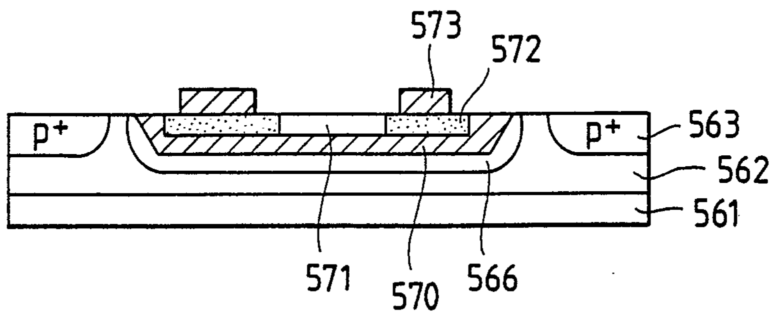


FIG. 32E

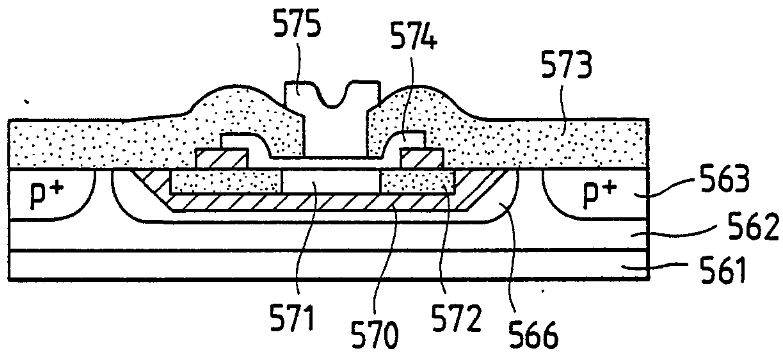


FIG. 32F

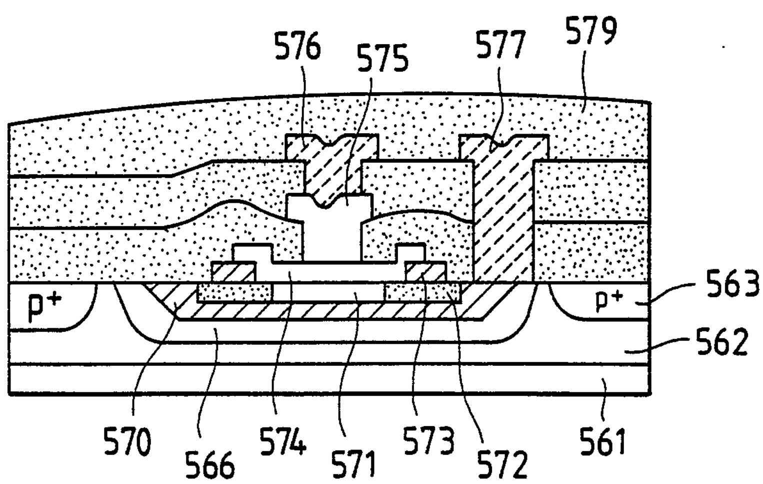


FIG. 32G

FIG. 33

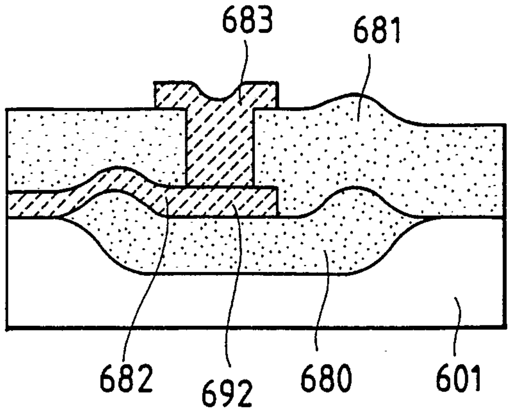


FIG. 34

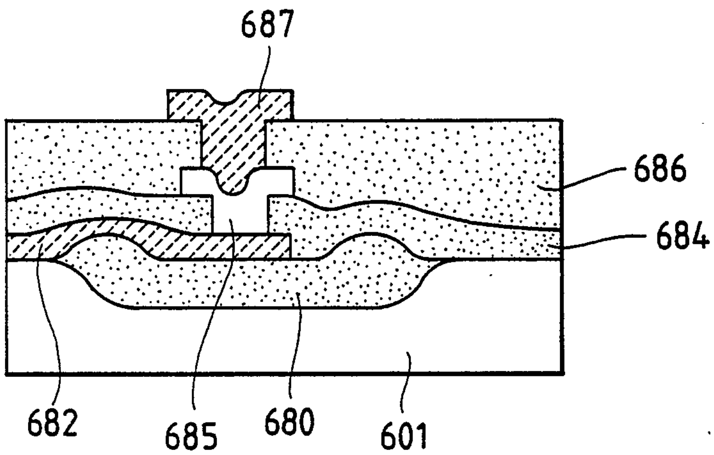


FIG. 35

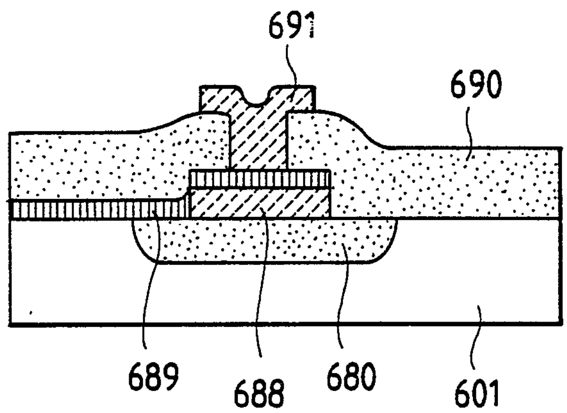

FIG. 36

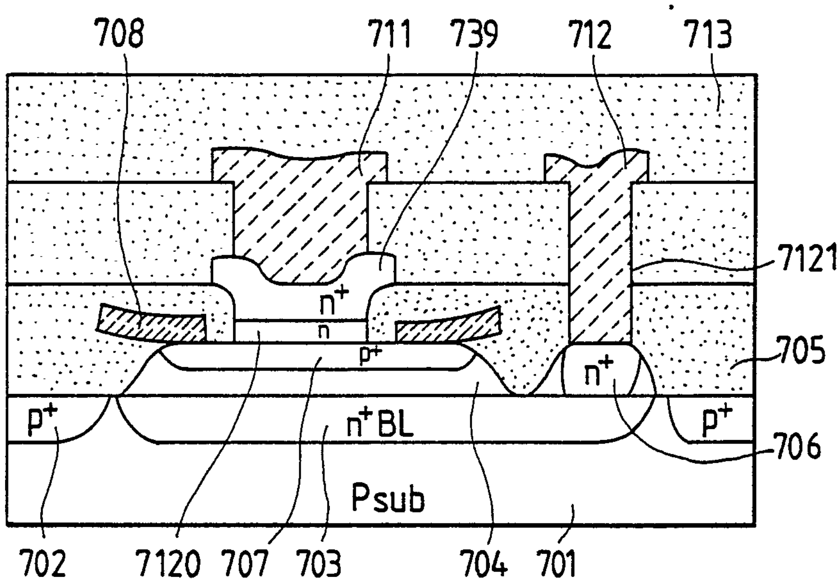
708
711
739
712
713
7121
n+
n
p+
n+
705
p+
n+BL
p+
706
Psub
702
7120
707
703
704
701

FIG. 37

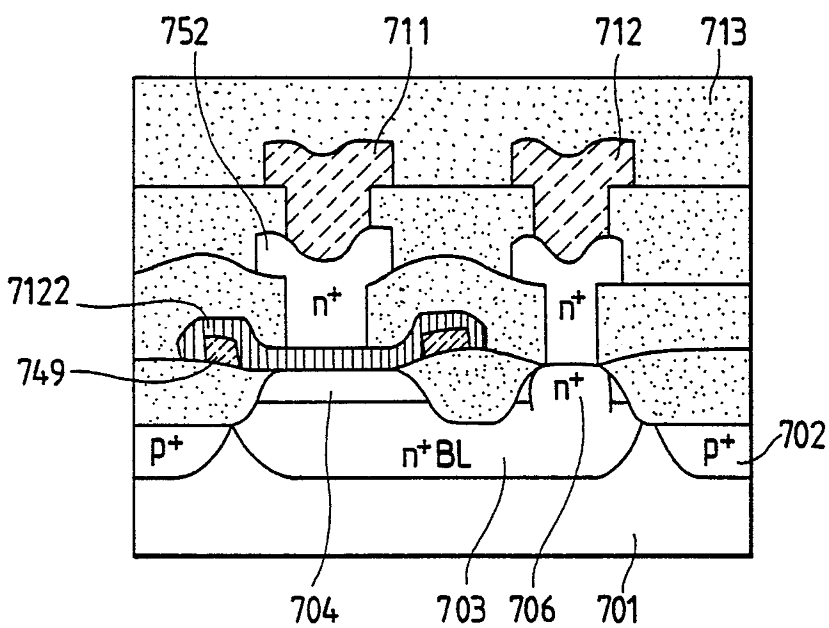
752
711
712
713
7122
n+
n+
749
n+
p+
n+BL
p+
702
704
703
706
701